# EUROPÄISCHE PATENTSCHRIFT

(11) **EP 2 438 005 B1**
(45) Veröffentlichungstag und Bekanntmachung des Hinweises auf die Patenterteilung: **10.06.2015**
(21) Anmeldenummer: 10715188.8
(22) Anmeldetag: 07.04.2010
(51) Int. Cl.: B81C 1/00

(54) **MIKROMECHANISCHES BAUELEMENT MIT EUTEKTISCHER VERBINDUNG ZWISCHEN ZWEI SUBSTRATEN UND VERFAHREN ZUM HERSTELLEN EINES DERARTIGEN MIKROMECHANISCHEN BAUELEMENTS**
MICROMECHANICAL COMPONENT HAVING EUTECTIC BOND BETWEEN TWO SUBSTRATES AND METHOD FOR PRODUCING SUCH A MICROMECHANICAL COMPONENT
COMPOSANT MICROMÉCANIQUE PRÉSENTANT UN JOINT EUTECTIQUE ENTRE DEUX SUBSTRATS ET PROCÉDÉ DE PRODUCTION D'UN TEL COMPOSANT MICROMÉCANIQUE

(30) Priorität: 02.06.2009 DE 102009026628
(43) Veröffentlichungstag der Anmeldung: 11.04.2012
(73) Patentinhaber: Robert Bosch GmbH, 70442 Stuttgart (DE)
(72) Erfinder: GONSKA, Julian, 72766 Reutlingen (DE); WEBER, Heribert, 72622 Nuertingen (DE)
(86) Internationale Anmeldenummer: PCT/EP2010/054584
(87) Internationale Veröffentlichungsnummer: WO 2010/139499

(56) Entgegenhaltungen:
- DE-A1- 19 619 921
- DE-A1-102007 044 806

## Beschreibung

Die vorliegende Erfindung betrifft ein mikromechanisches Bauelement und ein Verfahren zum Herstellen eines mikromechanischen Bauelements, wobei ein erstes und ein zweites Substrat miteinander verbunden werden.

### Stand der Technik

Mikromechanische Bauelemente, welche beispielsweise im Automobilbereich als Inertial- oder Beschleunigungssensoren zum Einsatz kommen, weisen üblicherweise eine Mikrostruktur mit beweglichen Funktionselementen auf. Die Mikrostruktur wird auch als MEMS-Struktur (Micro-Electromechanical. System) bezeichnet: Im Betrieb solcher Sensoren wird eine Auslenkung eines Funktionselements zum Beispiel durch eine Änderung der elektrischen Kapazität gegenüber einer festen Bezugselektrode erfasst.

Übliche Verfahren zum Herstellen eines mikromechanischen Bauelements umfassen ein Ausbilden der Mikrostruktur auf einem Funktionssubstrat (Sensorwafer) und ein Verbinden des Funktionssubstrats mit einem Kappensubstrat (Verkappung). Auf diese Weise wird ein die Funktionselemente umschließender Hohlraum ausgebildet, durch welchen die Funktionselemente hermetisch gegenüber der Umgebung abgedichtet sind. Auch kann eine vorgegebene Gas- oder Druckatmosphäre in dem Hohlraum eingestellt werden.

Ein bekanntes Verfahren zur Verkappung eines Funktionssubstrats ist in der DE 10 2007 044 806 A1 beschrieben. Bei diesem Verfahren wird das Kappensubstrat mit einem hervorstehenden zapfenförmigen Strukturelement ausgebildet. Das Funktionssubstrat wird mit einer Ausnehmung bereitgestellt, welche als Gegenstruktur für das hervorstehende Strukturelement des Kappensubstrats fungiert. Die beiden Substrate werden derart miteinander verbunden, dass die Zapfenstruktur des Kappensubstrats in die Ausnehmung des Funktionssubstrats eingreift und auf diese Weise ein die Mikrostruktur umlaufender Dichtbereich gebildet wird. In den Dichtbereich wird des Weiteren ein Verbindungsmedium eingebracht, um eine hermetisch dichte Verbindung zu erzeugen. Hierbei wird der Einsatz von Sealglas vorgeschlagen, welches mit Hilfe einer Siebdruckmaske auf die Zapfenstruktur vor Herstellen der Verbindung mit dem Funktionssubstrat aufgetragen wird.

Eine in der Mikrosystemtechnik zu beobachtende Entwicklung besteht in der zunehmenden Miniaturisierung von Bauteilen. Es besteht daher die Tendenz, neben den Funktionsstrukturen auch die Verbindungsbereiche (Verbindungs- oder Bondrahmen) von mikromechanischen Bauelementen kleiner und schmäler zu gestalten. Das oben beschriebene Auftragen von Sealglas mit Hilfe einer Siebdruckmaske stößt hierbei jedoch zunehmend an Grenzen und erscheint daher als ungeeignet, um die (zukünftigen) Miniaturisierungsanforderungen zu erfüllen. Darüber hinaus weist die auf dem Funktionssubstrat gemäß der DE 10 2007 044 806 A1 ausgebildete Ausnehmung im Querschnitt eine rechteckförmige Form auf, wodurch gegebenenfalls das Problem einer ungenügenden Haftung bestehen kann.

Die DE 196 19 921 A1 beschreibt ein weiteres Verfahren zum Herstellen eines mikromechanischen Bauelements. Das Verfahren umfasst ein Bereitstellen eines Funktionssubstrats, ein Bereitstellen eines Kappensubstrats mit einem hervorstehenden Strukturelement, und ein Verbinden der beiden Substrate über das hervorstehende Strukturelement. Hierbei wird ein eutektischer Bondprozess durchgeführt.

### Offenbarung der Erfindung

Die Aufgabe der vorliegenden Erfindung besteht darin, ein verbessertes Verfahren zum Herstellen eines mikromechanischen Bauelements anzugeben. Es ist weiterhin Aufgabe der Erfindung, ein verbessertes mikromechanisches Bauelement bereitzustellen.

Diese Aufgabe wird durch ein Verfahren gemäß Anspruch 1 und ein mikromechanisches Bauelement gemäß Anspruch 10 gelöst. Weitere vorteilhafte Ausführungsformen der Erfindung sind in den abhängigen Ansprüchen angegeben.

Erfindungsgemäß wird ein Verfahren zum Herstellen eines mikromechanischen Bauelements vorgeschlagen. Das Verfahren umfasst ein Bereitstellen eines ersten Substrats, ein Bereitstellen eines zweiten Substrats, ein Ausbilden eines hervorstehenden Strukturelements auf dem zweiten Substrat und ein Verbinden des ersten und zweiten Substrats über das hervorstehende Strukturelement. Das Verfahren zeichnet sich dadurch aus, dass das Verbinden des ersten und zweiten Substrats ein eutektisches Bonden umfasst.

Das Durchführen eines eutektischen Bondverfahrens bietet die Möglichkeit, einen Verbindungsbereich zwischen den beiden Substraten des mikromechanischen Bauelements mit relativ kleinen geometrischen Abmessungen und insbesondere mit einer kleinen Breite zu verwirklichen. Das hervorstehende Strukturelement des zweiten Substrats ermöglicht des Weiteren ein Aufbrechen von Oxidschichten beim Verbinden der Substrate, welche auf den zu verbindenden Oberflächen bzw. Schichten (Bondpartner) vorliegen können. Auf diese Weise kann die die Verbindung ermöglichende eutektische Reaktion relativ schnell eintreten.

Erfindungsgemäß wird eine Ausnehmung auf dem ersten Substrat ausgebildet. Das erste und zweite Substrat werden derart verbunden, dass das hervorstehende Strukturelement des zweiten Substrats in die Ausnehmung des ersten Substrats eingreift. Hierdurch ist es möglich, die Bondverbindung zwischen dem ersten und zweiten Substrat mit einer hohen Stabilität zu erzeugen. Insbesondere kann eine hohe Verbindungsfestigkeit gegenüber lateral zwischen den Substraten wirkenden Kräften bzw. Scherkräften erzielt werden.

Erfindungsgemäß umfasst die Ausnehmung des ersten Substrats einen Bodenbereich und Seitenwände. Die Seitenwände weisen angrenzend an den Bodenbereich Aussparungen auf, in welche eine bei dem eutektischen Bonden gebildete eutektische Legierung einfließt. Auf diese Weise kann eine Verkeilung bzw. Verzahnung bewirkt werden, wodurch sich die Stabilität der Bondverbindung weiter verbessern lässt.

Gemäß einer bevorzugten Ausführungsform wird das hervorstehende Strukturelement des zweiten Substrats mit einer Verbindungsschicht ausgebildet. Bei dem Verbinden des ersten und zweiten Substrats bilden die Verbindungsschicht des zweiten Substrats und Material des ersten Substrats die eutektische Legierung. Da lediglich eine Verbindungsschicht ausgebildet wird, lässt sich diese Ausführungsform auf relativ einfache Weise verwirklichen.

Gemäß einer alternativen bevorzugten Ausführungsform wird eine erste Verbindungsschicht auf dem ersten Substrat ausgebildet. Das hervorstehende Strukturelement des zweiten Substrats wird mit einer zweiten Verbindungsschicht ausgebildet. Bei dem Verbinden des ersten und zweiten Substrats bilden die erste und zweite Verbindungsschicht die eutektische Legierung.

Gemäß einer weiteren bevorzugten Ausführungsform wird das hervorstehende Strukturelement des zweiten Substrats mit einer Schutzschicht ausgebildet, auf welcher die oben genannte Verbindungsschicht bzw. die zweite Verbindungsschicht ausgebildet wird. Die Schutzschicht dient dazu, ein Aufschmelzen von Material des hervorstehenden Strukturelements unter der Schutzschicht bei dem Verbinden des ersten und zweiten Substrats zu verhindern. Auf diese Weise kann das Mischungsverhältnis der im Rahmen des Bondens gebildeten eutektischen Legierung genau eingestellt werden, um eine zuverlässige Haftung zwischen dem ersten und zweiten Substrat zu bewirken.

In diesem Zusammenhang weist die Verbindungsschicht des hervorstehenden Strukturelements vorzugsweise zwei aufeinander angeordnete Schichten mit unterschiedlichen Materialien auf. Der Einsatz der zweischichtigen Verbindungsschicht bietet die Möglichkeit, die Haftung und Verbindungsstabilität in Bezug auf die Schutzschicht zu verbessern.

Gemäß einer weiteren bevorzugten Ausführungsform wird eine Erhöhungsstruktur in einem Verbindungsbereich auf dem ersten Substrat oder auf dem hervorstehenden Strukturelement des zweiten Substrats ausgebildet. Die Erhöhungsstruktur kann hierbei als "Dichtlippe" fungieren, welche als schmale und durchgängige Struktur innerhalb des Verbindungsbereichs bzw. Bondrahmens verlaufen kann. Auf diese Weise besteht die Möglichkeit, das Auftreten von lediglich lokalen Kontakten zwischen den zu verbindenden Oberflächen bzw. Bondpartnern aufgrund von Topographieunterschieden zwischen den Substraten zu verhindem. Zu Beginn des Bondens kann es im Bereich der Erhöhungsstruktur zu einem Aufschmelzen des Gefüges kommen. Durch ein im Rahmen des Bondens durchgeführtes Aneinanderdrücken der Substrate und der dabei im Bereich der Erhöhungsstruktur hervorgerufenen hohen Flächenanpresskraft kann die lokal entstehende Schmelze verdrängt und die in dem Verbindungsbereich angeordnete Erhöhungsstruktur weiter in die entstehende "Schmelzfront" hineingedrückt werden. Daher kann es zum Kontakt der Bondpartner und zur Ausbildung einer eutektischen Legierung auch im restlichen Bondrahmenbereich kommen, wodurch sich eine hermetisch dichte Bondverbindung erzeugen lässt.

Ein gemäß des Verfahrens hergestelltes mikromechanisches Bauelement weist ein erstes und ein zweites Substrat auf. Das zweite Substrat weist ein hervorstehendes Strukturelement auf, über welches das erste und zweite Substrat verbunden sind. Das mikromechanische Bauelement zeichnet sich dadurch aus, dass die Verbindung des ersten und zweiten Substrats durch eine durch eutektisches Bonden im Bereich des hervorstehenden Strukturelements gebildete eutektische Legierung hergestellt ist. Hierdurch besteht die Möglichkeit, dass das mikromechanische Bauelement einen Verbindungsbereich zwischen den beiden Substraten mit relativ kleinen geometrischen Abmessungen aufweist.

Erfindungsgemäß weist das erste Substrat eine Ausnehmung auf. Das erste und zweite Substrat sind derart verbunden, dass das hervorstehende Strukturelement des zweiten Substrats in die Ausnehmung des ersten Substrats eingreift. In dieser Ausgestaltung weist das mikromechanische Bauelement eine hohe Verbindungsfestigkeit, vor allem gegenüber Scherkräften, auf.

Gemäß einer bevorzugten Ausführungsform weist das mikromechanische Bauelement weiter Abstandshalter zwischen dem ersten und zweiten Substrat außerhalb der Ausnehmung auf. Durch die Abstandshalter können die beiden Substrate in einem definierten Abstand zueinander angeordnet werden. Der definierte Abstand bietet beispielsweise die Möglichkeit, die Bewegung eines auf einem Substrat angeordneten Funktionselements mit einer hohen Genauigkeit kapazitiv über eine in dem anderen Substrat angeordnete Bezugselektrode auszuwerten.

Erfindungsgemäß wird ferner ein mikromechanisches Bauelement vorgeschlagen, welches ein erstes Substrat und ein zweites Substrat aufweist. Das erste Substrat weist eine Ausnehmung, und das zweite Substrat weist ein hervorstehendes Strukturelement auf. Das erste und zweite Substrat sind derart verbunden, dass das hervorstehende Strukturelement in die Ausnehmung eingreift. Die Verbindung des ersten und zweiten Substrats ist hierbei durch ein in der Ausnehmung angeordnetes Verbindungsmedium hergestellt. Das mikromechanische Bauelement zeichnet sich dadurch aus, dass die Ausnehmung des ersten Substrats einen Bodenbereich und Seitenwände umfasst, wobei die Seitenwände angrenzend an den Bodenbereich Aussparungen aufweisen, welche von dem Verbindungsmedium ausgefüllt sind. Des weiteren ist das Verbindungsmedium eine eutektische Legierung. Bei diesem mikromechanischen Bauelement bewirkt das Ausfüllen der Aussparungen der Ausnehmung durch das Verbindungsmedium eine Verkeilung bzw. Verzahnung, so dass das Bauelement eine hohe Verbindungsfestigkeit aufweist. Durch die Ausgestaltung des Verbindungsmediums als eutektische Legierung wird eine hohe Verbindungsstabilität weiter begünstigt.

Gemäß einer bevorzugten Ausführungsform weist das hervorstehende Strukturelement des zweiten Substrats eine Schutzschicht auf, welche mit dem Verbindungsmedium verbunden ist. Die Schutzschicht bietet die Möglichkeit, ein unerwünschtes Aufschmelzen von Material des Strukturelements bei einem Herstellen des Bauelements durch Verbinden der beiden Substrate zu vermeiden.

Gemäß einer weiteren bevorzugten Ausführungsform weist das mikromechanische Bauelement weiter eine Erhöhungsstruktur auf dem ersten Substrat in der Ausnehmung oder auf dem hervorstehenden Strukturelement des zweiten Substrats auf. Die Erhöhungsstruktur kann beispielsweise als mechanischer Anschlag fungieren, um zu verhindern, dass das Verbindungsmedium beim Verbinden der Substrate vollständig zwischen dem Bodenbereich der Ausnehmung des ersten Substrats und dem hervorstehenden Strukturelement herausgedrängt wird.

Die Erfindung wird im Folgenden anhand der Figuren näher erläutert. Es zeigen:
Figuren 1 bis 3 ein Verfahren zur Herstellung eines mikromechanischen Bauelements durch Verbinden eines Funktionssubstrats mit einer Nut und eines Kappensubstrats mit einer Zapfenstruktur;
Figur 4 eine alternative Ausgestaltung des Herstellungsverfahrens, wobei zusätzlich Abstandshalter zum Einsatz kommen;
Figur 5 eine weitere alternative Ausgestaltung des Herstellungsverfahrens, wobei eine Verbindungsschicht auch auf Seitenwänden der Zapfenstruktur angeordnet ist;
Figuren 6 und 7 eine weitere Ausgestaltung des Herstellungsverfahrens, wobei das Funktionssubstrat eine Erhöhung in der Nut aufweist;
Figuren 8 bis 10 alternative Ausgestaltungen der Erhöhungsstruktur des Funktionssubstrats;
Figuren 11 und 12 eine weitere Variante des Verfahrens, wobei die Zapfenstruktur des Kappensubstrats eine Schutzschicht und eine zweischichtige Verbindungsschicht aufweist;
Figur 13 eine Darstellung einer Zapfenstruktur mit einer Erhöhung;
Figur 14 eine weitere Ausgestaltung des Herstellungsverfahrens mit einer eine Erhöhung aufweisenden Zapfenstruktur;
Figuren 15 und 16 weitere Ausgestaltung des Herstellungsverfahrens, wobei die Verbindung direkt über das Funktionssubstrat erfolgt;
Figur 17 eine Variante des Verfahrens mit einer Erhöhung auf dem Funktionssubstrat;
Figuren 18 und 19 eine weitere Ausgestaltung des Herstellungsverfahrens, wobei die Zapfenstruktur des Kappensubstrats eine Schutzschicht und eine zweischichtige Verbindungsschicht aufweist;
Figur 20 eine weitere Ausgestaltung des Herstellungsverfahrens, wobei das Funktionssubstrat eine Erhöhung, jedoch keine Nut aufweist;
Figuren 21 und 22 eine Variante des Verfahrens, wobei die Zapfenstruktur des Kappensubstrats eine Schutzschicht und eine zweischichtige Verbindungsschicht aufweist;
Figuren 23 bis 25 ein weiteres Verfahren zur Herstellung eines mikromechanischen Bauelements durch Verbinden eines Funktionssubstrats mit einer Nut und eines Kappensubstrat mit einer Zapfenstruktur;
Figur 26 eine alternative Ausgestaltung des Herstellungsverfahrens, wobei zusätzlich Abstandshalter zum Einsatz kommen;
Figuren 27 und 28 eine weitere Ausgestaltung des Herstellungsverfahrens, wobei das Funktionssubstrat eine Erhöhung in der Nut aufweist;
Figuren 29 bis 31 alternative Ausgestaltungen der Erhöhungsstruktur des Funktionssubstrats; und
Figuren 32 bis 34 weitere Varianten des Herstellungsverfahrens, wobei eine Erhöhung und/oder eine Schutzschicht zum Einsatz kommen.

Die folgenden Figuren zeigen jeweils in einer schematischen seitlichen Schnittdarstellung die Herstellung eines mikromechanischen Bauelements durch Verbinden eines Funktionssubstrats 100 und eines Kappensubstrats 200. Auf diese Weise kann ein auf dem Funktionssubstrat 100 ausgebildeter Sensorbereich 135, welcher ein oder mehrere bewegliche Funktionselemente und optional integrierte Schaltkreise aufweist, hermetisch gegenüber der Umgebung abgedichtet werden. Denkbar ist es auch, dass das Kappensubstrat 200 integrierte Schaltkreise aufweist. Der Sensorbereich 135 ist lediglich in einigen der gezeigten Figuren angedeutet. Bei den Herstellungsverfahren, welche im Folgenden beschrieben werden, können in der Halbleiter- bzw. Mikrosystemtechnik übliche Verfahrensprozesse und Materialien zum Einsatz kommen, so dass hierauf nur teilweise eingegangen wird. Darüber hinaus wird darauf hingewiesen, dass neben den dargestellten und beschriebenen Verfahrensschritten weitere Verfahrensschritte durchgeführt werden können, um die Herstellung eines mikromechanischen Bauelements zu vervollständigen. Hierunter fällt beispielsweise die Ausbildung von Kontakten auf den Substraten 100, 200 für eine externe Kontaktierung. In Betracht kommt ferner ein Rückdünnen der Substrate 100, 200 an deren Rückseiten und ein Vereinzelungsprozess, um voneinander getrennte mikromechanische Bauelemente bereitzustellen.

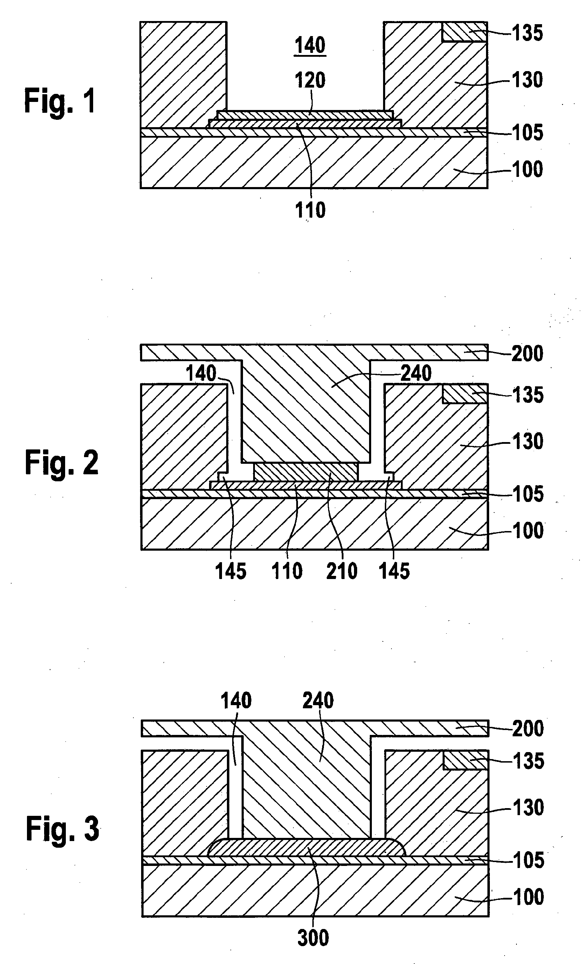

Die Figuren 1 bis 3 zeigen ein erstes Verfahren zur Herstellung eines mikromechanischen Bauelements aus einem Funktionssubstrat 100 und einem Kappensubstrat 200. Bei dem mikromechanischen Bauelement kann es sich beispielsweise um einen Beschleunigungssensor handeln, welcher in einem Kraftfahrzeug einsetzbar ist.

Figur 1 zeigt eine Darstellung des Funktionssubstrats 100 nach Durchführen einer Reihe von Verfahrensschritten. Zu Beginn wird ein Substrat 100 bereitgestellt, bei dem es sich beispielsweise um einen gängigen Wafer aus Silizium handelt. Auf das Substrat 100 wird eine Isolationsschicht 105 aufgebracht, welche beispielsweise Siliziumoxid aufweist. Anstelle einer einzelnen Schicht kann die Isolationsschicht 105 auch mehrere Schichten umfassen. Insbesondere ist es vorstellbar, dass innerhalb der Isolationsschicht 105 eine oder mehrere eingefasste Leiterbahnebenen vorgesehen sind. Derartige Leiterbahnstrukturen dienen dazu, eine Kontaktierung des mikromechanischen Bauelements zu ermöglichen.

Auf der Isolationsschicht 105 wird eine strukturierte Verbindungsschicht 110 ausgebildet, welche in einem späteren Verfahrensstadium zum Bilden einer eutektischen Legierung eingesetzt wird. Als Material für die Verbindungsschicht 110 kommt beispielsweise Silizium bzw. Polysilizium oder Germanium in Betracht. Auf der Verbindungsschicht 110 wird des Weiteren eine strukturierte Opferschicht 120 ausgebildet, welche wie in Figur 1 dargestellt von den lateralen Abmessungen her kleiner sein kann als die Verbindungsschicht 110. Alternativ kann die Opferschicht 120 auch die gleichen Abmessungen aufweisen oder auch größer sein wie die Verbindungsschicht 110. Als Material für die Opferschicht 120 kommt beispielsweise Siliziumoxid in Betracht.

Auf diese Schichtanordnung wird eine relativ dicke Funktionsschicht 130 aufgebracht, in welcher die Funktionselemente des mikromechanischen Bauelements ausgebildet werden. Eine mögliche Lage bzw. ein Bereich der Funktionselemente ist in Figur 1 anhand eines Sensorbereichs 135 angedeutet. Bei der Funktionsschicht 130 kann es sich um eine sogenannte Epi-Polysiliziumschicht handeln, d.h. eine in einem Epitaxieverfahren erzeugte polykristalline Siliziumschicht.

Das Erzeugen von Funktionselementen in dem Sensorbereich 135 umfasst beispielsweise das Durchführen eines Grabenätzverfahrens, welches auch als "Trenchen" bezeichnet wird. Zum Grabenätzen kann ein alternierender Trockenätzprozess wie beispielsweise der sogenannte Bosch-Prozess durchgeführt werden. Im Rahmen des Grabenätzens wird wie in Figur 1 dargestellt eine Ausnehmung bzw. Nut 140 in der Funktionsschicht 130 ausgebildet. Hierbei dient die Opferschicht 120 als Ätzstoppschicht, um eine Beschädigung der Verbindungsschicht 110 zu vermeiden. Die Nut 140 weist eine (in der Aufsicht) geschlossene Form auf, welche den Sensorbereich 135 umläuft.

Ein weiterer Prozess, welcher im Rahmen des Herstellens der Mikrostruktur in dem Sensorbereich 135 durchgeführt wird, ist ein Gasphasenätzprozess. Bei diesem Prozess, bei welchem zum Beispiel Flusssäuredampf zum Einsatz kommt, werden die durch das Grabenätzen vorstrukturierten Funktionselemente der Mikrostruktur freigelegt. Im Hinblick auf die Nut 140 hat das Gasphasenätzen zur Folge, dass die Opferschicht 120 wie in Figur 2 dargestellt entfernt wird, so dass Seitenwände der Nut 140 angrenzend an den durch die Verbindungsschicht 110 gebildeten Bodenbereich Unterätzungen bzw. Aussparungen 145 aufweisen. Die Aussparungen 145 tragen dazu bei, die Verbindungsfestigkeit des mikromechanischen Bauelements, wie weiter unten beschrieben, zu erhöhen.

Figur 2 zeigt des Weiteren das Kappensubstrat 200, welches mit dem Funktionssubstrat 100 zum Herstellen des mikromechanischen Bauelements verbunden wird. Das Kappensubstrat 200 dient dazu, den Sensorbereich 135 hermetisch gegenüber der Umgebung abzudichten.

Figur 2 zeigt eine Darstellung des Kappensubstrats 200 nach Durchführen einer Reihe von Verfahrensschritten. Zu Beginn wird ein Substrat 200 bereitgestellt, bei dem es sich wie bei dem (ursprünglichen) Substrat 100 beispielsweise um einen gängigen Wafer aus Silizium handelt. Das Substrat 200 wird ferner mit einem hervorstehenden zapfenförmigen Strukturelement 240 versehen, welches im Folgenden als Zapfenstruktur 240 bezeichnet wird. Zum Herstellen der Zapfenstruktur 240 wird ein Strukturierungs- bzw. Ätzverfahren durchgeführt. Die Zapfenstruktur 240 ist auf die Nut 140 des Funktionssubstrats 100 abgestimmt und weist daher wie die Nut 140 eine (in der Aufsicht) geschlossene umlaufende Form auf. Im Rahmen des Strukturierens der Zapfenstruktur 240 wird des weiteren eine Kavität bzw. Kaverne auf dem Kappensubstrat 200 ausgebildet, welche von der Zapfenstruktur 240 umgeben oder eingefasst wird. Nach dem Verbinden der Substrate 100, 200 ist der Sensorbereich 135 des Funktionssubstrats 100 innerhalb der Kavität angeordnet.

Die Zapfenstruktur 240 wird des Weiteren wie in Figur 2 dargestellt mit einer auf der Unterseite angeordneten strukturierten Verbindungsschicht 210 ausgebildet. Die Verbindungsschicht 210 kann vor oder alternativ nach dem Strukturieren der Zapfenstruktur 240 auf das Kappensubstrat 200 aufgebracht werden, so dass eine Strukturierung der Verbindungsschicht 210 im Rahmen der Strukturierung der Zapfenstruktur 240 oder durch ein zusätzliches Strukturierungsverfahren erfolgen kann. Entgegen der Darstellung in Figur 2 kann sich die Verbindungsschicht 210 auch über die gesamte Breite der Zapfenstruktur 240 bzw. deren Stirnseite (Unterseite) erstrecken.

Das Material der Verbindungsschicht 210 der Zapfenstruktur 240 ist auf das Material der Verbindungsschicht 110 des Funktionssubstrats 100 abgestimmt, um die Bildung einer eutektischen Legierung 300 aus den beiden Verbindungsschichten 110, 210 bewirken zu können (siehe Figur 3). Für den Fall einer Silizium aufweisenden Verbindungsschicht 110 kann die Verbindungsschicht 210 beispielsweise Gold, und im Falle von Germanium beispielsweise Aluminium aufweisen.

Zum Verbinden der beiden Substrate 100, 200 wird die Zapfenstruktur 240 wie in Figur 2 dargestellt in die Nut 140 eingeführt und ein eutektisches Bondverfahren durchgeführt, bei dem die Substrate 100, 200 unter Einwirkung einer vorgegebenen Temperatur aneinander gedrückt werden. Dies hat zur Folge, dass die Verbindungsschichten 110, 210 aufschmelzen und wie in Figur 3 dargestellt eine eutektische Legierung 300 (Eutektikum) bilden. Durch das Andrücken der Substrate 100, 200 wird des Weiteren erzielt, dass das Eutektikum 300 in die Aussparungen 145 einfließt und die Aussparungen 145 ausfüllt. Hierbei kann auch ein Teil der Funktionsschicht 130 im Bereich der Aussparungen 145 aufschmelzen und, wie in Figur 3 angedeutet, an dem Eutektikum 300 beteiligt sein. Dies gilt in entsprechender Weise für einen vor dem Aufschmelzen unter der Verbindungsschicht 210 vorliegenden Teilbereich der Zapfenstruktur 240 (in der Darstellung von Figur 2 "oberhalb" der Verbindungsschicht 210).

Nach dem Abkühlen bzw. Aushärten des Eutektikums 300 sind die beiden Substrate 100, 200 hermetisch dicht über das Eutektikum 300 miteinander verbunden. Das Verbinden der beiden Substrate 100, 200 kann bei einer definierten Atmosphäre mit einem vorgegebenen (beispielsweise sehr geringen) Atmosphärendruck durchgeführt werden, um einen definierten Innendruck in der von den beiden Substraten 100, 200 eingefassten Kavität einzustellen, in welchem der Sensorbereich 135 angeordnet ist.

Das beschriebene Verfahren bietet die Möglichkeit, die Verbindung zwischen den Substraten 100, 200 über die in die Nut 140 eingreifende Zapfenstruktur 240, auch als Verbindungs- oder Bondrahmen bezeichnet, mit kleinen Abmessungen und insbesondere einer kleinen Breite zu verwirklichen. Beim Herstellen der an dem eutektischen Bonden beteiligten Strukturen und Schichten können fotolithographische Strukturierungsverfahren und Ätztechniken zum Einsatz kommen, welche eine solche Miniaturisierung des Bondrahmens ermöglichen. Aufgrund der Zapfenstruktur 240 wird ferner beim Andrücken der Substrate 100, 200 ein relativ hoher Flächenanpressdruck im Bereich der Verbindungsschichten 110, 210 ermöglicht, wodurch auf den Verbindungsschichten 110, 210 gegebenenfalls vorliegende (native) Oxidschichten aufgebrochen werden können, und das Aufschmelzen der Schichten 110, 210 bzw. die Bildung des Eutektikums 300 relativ schnell eintreten kann. Das Eingreifen der Zapfenstruktur 240 in die Nut 140 ermöglicht ferner- selbst einem relativ schmalen Bondrahmen - eine hohe Verbindungsfestigkeit des mikromechanischen Bauelements, vor allem gegenüber lateral zwischen den Substraten 100, 200 wirkenden Kräften bzw. Scherkräften. Das Ausfüllen der seitlichen Aussparungen 145 der Nut 140 durch das Eutektikum 300 bewirkt darüber hinaus eine Verkeilung bzw. Verzahnung, wodurch die Stabilität der Verbindung weiter begünstigt wird.

Anhand der folgenden Figuren werden Abwandlungen bzw. Variationen des anhand der Figuren 1 bis 3 erläuterten Herstellungsverfahrens beschrieben. Auf Details zu übereinstimmenden bzw. entsprechenden Verfahrensschritten und Komponenten wird daher auf die obigen Ausführungen Bezug genommen. Hierbei ist darauf hinzuweisen, dass Merkmale von einzelnen Ausführungsformen auch mit anderen Varianten kombiniert werden können.

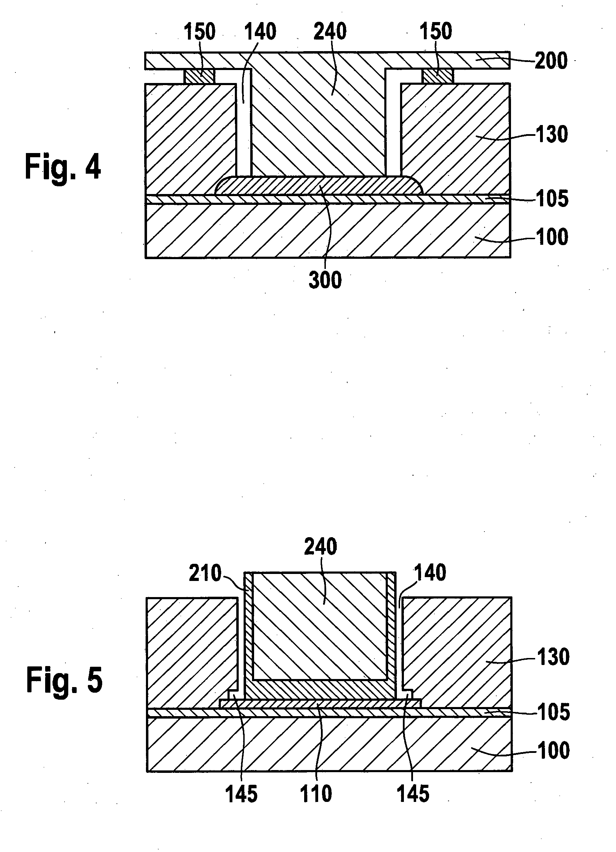

Figur 4 zeigt eine alternative Ausgestaltung, wobei zwischen dem Funktionssubstrat 100 bzw. der Funktionsschicht 130 und dem Kappensubstrat 200 außerhalb der Nut 140 Abstandshalter 150 vorgesehen sind. Die Abstandshalter 150 werden vor dem Verbinden der Substrate 100, 200 hergestellt. Das Erzeugen der Abstandshalter 150 umfasst beispielsweise ein Strukturieren der Funktionsschicht 130 oder ein Aufbringen einer weiteren Schicht (zum Beispiel aus Siliziumoxid) auf der Funktionsschicht 130 und Strukturieren der weiteren Schicht.

Durch die Abstandshalter 150 können die beiden Substrate 100, 200 in einem vorgegebenen Abstand zueinander angeordnet werden. Der definierte Abstand bietet beispielsweise die Möglichkeit, die Position bzw. Bewegung eines Funktionselements der Mikrostruktur des Funktionssubstrats 100 mit einer hohen Genauigkeit kapazitiv über eine in dem Kappensubstrat 200 angeordnete Bezugselektrode zu erfassen. Des Weiteren können die Abstandshalter 150 dazu verwendet werden, um ein maximales Maß an Verdrängung für das aufgeschmolzende Eutektikum 300 beim Verbinden bzw. Aneinanderdrücken der Substrate 100, 200 festzulegen. Auf diese Weise kann insbesondere sichergestellt werden, dass das Eutektikum 300 nicht vollständig aus dem Zwischenbereich zwischen der Unterseite der Zapfenstruktur 240 und der Isolationsschicht 105 herausgedrängt wird, was gegebenenfalls eine Verschlechterung der Haftung und/oder Abdichtung zur Folge hat.

Anstelle die Abstandshalter 150 auf dem Funktionssubstrat 100 bzw. der Funktionsschicht 130 vorzusehen, ist es auch möglich, die Abstandshalter 150 neben der Zapfenstruktur 240 auf dem Kappensubstrat 200 auszubilden. Dies kann beispielsweise durch Strukturieren des Kappensubstrats 200 oder Aufbringen einer weiteren Schicht auf das Kappensubstrat 200 und Strukturieren derselben erfolgen. Des weiteren ist es auch vorstellbar, die beiden Substrate 100, 200 derart zu verbinden, dass die in den Figuren seitlich von der Zapfenstruktur 240 angedeutete Kante bzw. Oberfläche des Kappensubstrats 200 oder ein Teilbereich hiervon auf der Funktionsschicht 130 aufliegt (nicht dargestellt). Auch auf diese Weise kann ein definierter Abstand zwischen den Substraten 100, 200 mit den oben beschriebenen Wirkungen festgelegt werden.

Figur 5 zeigt eine weitere alternative Ausgestaltung des Herstellungsverfahrens vor dem Ausbilden des Eutektikums 300, wobei die Verbindungsschicht 210 hierbei nicht nur auf der Unterseite, sondern auch auf Seitenwänden der Zapfenstruktur 240 vorgesehen ist. Hierdurch ist die Möglichkeit gegeben, einen gegebenenfalls zur Strukturierung der (großflächig abgeschiedenen) Verbindungsschicht 210 eingesetzten Strukturierungsprozess wegzulassen.

Bei den vorstehend beschriebenen Verfahren kann gegebenenfalls das Problem bestehen, dass Topographieunterschiede zwischen den Substraten 100, 200 einen nur teilweisen oder lokalen Kontakt zwischen den Verbindungsschichten 110, 210 bewirken. Dies kann dazu führen, dass sich das Eutektikum 300 nicht in dem gesamten Verbindungsbereich innerhalb der Nut 140 ausbildet und infolgedessen eine Undichtigkeit in dem Verbindungsbereich vorliegen kann. Ein solcher Effekt kann dadurch vermieden werden, dass in dem Verbindungsbereich eine als "Dichtlippe" fungierende Erhöhungsstruktur vorgesehen wird, an welcher sich das Eutektikum 300 lokal ausbilden kann. Durch das im Rahmen des Bondens durchgeführte Aneinanderdrücken der Substrate 100, 200 und der dabei im Bereich der Erhöhungsstruktur hervorgerufenen hohen Flächenanpresskraft kann das aufgeschmolzene Eutektikum 300 weiter in andere Bereiche des Verbindungsrahmens verdrängt werden, so dass es zur Ausbildung einer hermetisch dichten Verbindung in dem gesamten Verbindungsbereich kommt. Mögliche Ausführungsformen mit einer solchen Erhöhungsstruktur sind in den folgenden Figuren dargestellt.

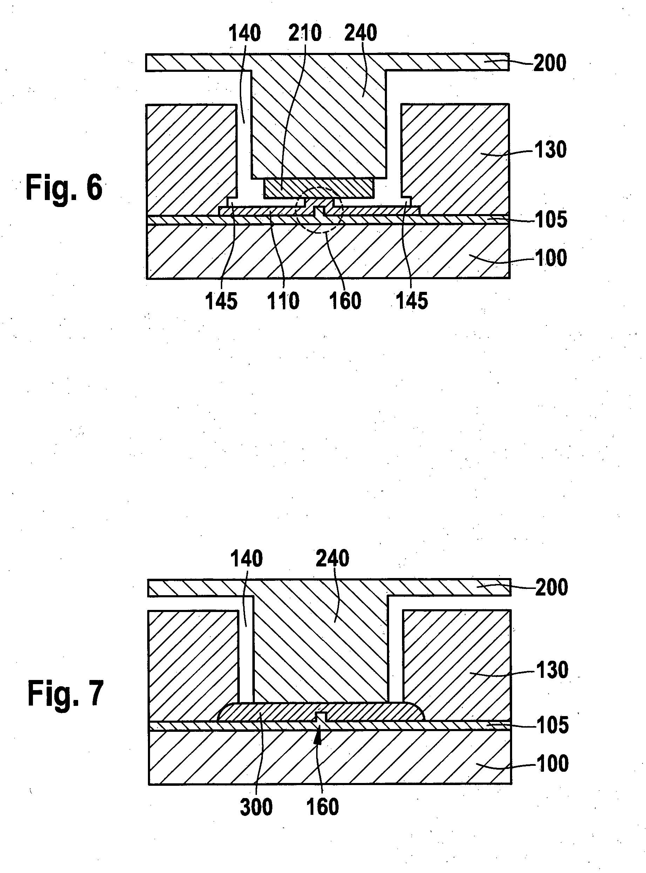

Die Figuren 6 und 7 zeigen eine Ausgestaltung des Herstellungsverfahrens, wobei auf dem Funktionssubstrat 100 wie in Figur 6 dargestellt eine Erhöhung 160 innerhalb der Nut 140 vorgesehen ist. Dies kann beispielsweise durch zusätzliches Strukturieren der auf das (ursprüngliche) Substrat 100 aufgebrachten Isolationsschicht 105 (bzw. einer oder mehrerer Schichten der als Schichtensystem aufgebauten Isolationsschicht 105) bewirkt werden, so dass auch die nachträglich auf der Isolationsschicht 105 ausgebildete Verbindungsschicht 110 im Bereich der Erhöhung 160 eine stufenförmige Form aufweist. Nach dem Erzeugen des Eutektikums 300 kann die (nunmehr allein durch die Isolationsschicht 105 gebildete) Erhöhung 160 wie in Figur 7 dargestellt von dem Eutektikum 300 eingeschlossen sein. Hierbei ist es auch vorstellbar, dass die Erhöhung 160 direkt an die Unterseite der Zapfenstruktur 240 angrenzt (nicht dargestellt).

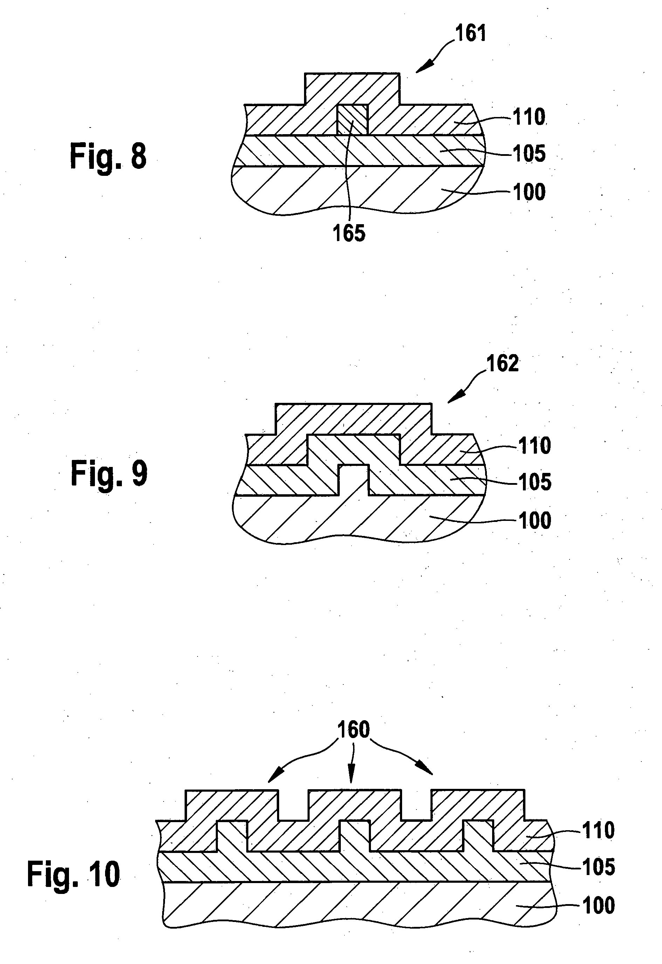

Eine derartige Erhöhungsstruktur (innerhalb der Nut 140) kann auch auf andere Art und Weise verwirklicht werden. Eine mögliche Ausgestaltung ist die in Figur 8 dargestellte Erhöhung 161. Hierbei wird auf der Isolationsschicht 105 eine zusätzliche strukturierte Erhöhungsschicht 165 ausgebildet. Die Erhöhungsschicht 165 weist vorzugsweise ein temperaturbeständiges Material auf, um insbesondere im Zusammenhang mit nachfolgenden und bei hohen Temperaturen durchgeführten Prozessen verwendet zu werden. Ein solcher Prozess ist zum Beispiel ein Aufbringen der Schicht 130 als Epi-Polysiliziumschicht durch Schichtabscheidung in einem Epitaxie-Reaktor. Mögliche temperaturbeständige Materialen für die Erhöhungsschicht 165 sind zum Beispiel Polysilizium, Siliziumnitrit, Siliziumkarbid oder Siliziumoxid.

Alternativ besteht die Möglichkeit, das bereitgestellte Substrat 100 zu strukturieren, um, wie in Figur 9 dargestellt, eine Erhöhung 162 bereitzustellen. Hierbei weisen die nachfolgend ausgebildeten Schichten 105, 110 im Bereich der Erhöhung 162 einen entsprechenden stufenförmigen Verlauf auf. Anstelle einer einzelnen Erhöhung ist es auch denkbar, mehrere Erhöhungen vorzusehen. Zur Veranschaulichung zeigt Figur 10 ein mögliches Beispiel, wobei das Funktionssubstrat 100 hierbei drei Erhöhungen 160 aufweist. Die Erhöhungen 160 können hierbei in einem gleichen Abstand bzw. parallel zueinander angeordnet sein. Hinsichtlich des Einsatzes von Erhöhungsstrukturen besteht die Möglichkeit, diese auch mit den in Figur 4 dargestellten Abstandshaltern 150 zu kombinieren (nicht dargestellt).

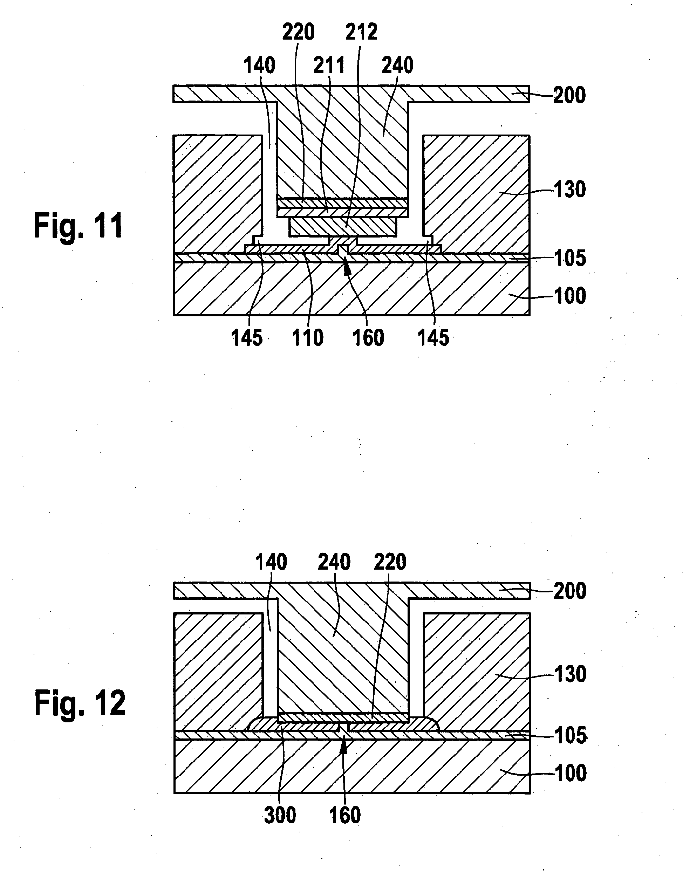

Die Figuren 11 und 12 zeigen eine weitere Ausgestaltung des Herstellungsverfahrens. Hierbei ist die Zapfenstruktur 240 wie in Figur 11 dargestellt mit einer zusätzlichen Schutzschicht 220 versehen, welche beispielsweise Siliziumoxid aufweist. Darüber hinaus ist als Verbindungsschicht der Zapfenstruktur 240 eine Schichtanordnung aus zwei Schichten 211, 212 vorgesehen, welche auf der Schutzschicht 220 angeordnet sind. Dieser zweischichtige Aufbau hat den Zweck, eine verbesserte Haftung auf der Schutzschicht 220 zu erzielen.

Als Material für die Verbindungsschicht 212 kommt beispielsweise (entsprechend der in den vorhergehenden Figuren gezeigten Verbindungsschicht 210) Gold in Betracht, welches jedoch eine ungenügende Haftung auf einer aus Siliziumoxid gebildeten Schutzschicht 220 aufweisen kann, insbesondere beim Aufschmelzen im Rahmen des eutektischen Bondens. Ein derartiges Haftungsproblem kann durch die zwischen der Verbindungsschicht 212 und der Schutzschicht 220 angeordnete weitere Verbindungsschicht 211 vermieden werden, welche wie die Verbindungsschicht 110 auf dem Funktionssubstrat 100 beispielsweise Silizium aufweist. Entsprechende Gegebenheiten können auch für eine Aluminium umfassende Verbindungsschicht 212 auf einer Siliziumoxid umfassenden Schutzschicht 220 vorliegen. Hierbei kann eine verbesserte Haftung durch eine aus Germanium aufgebaute Verbindungsschicht 211 erzielt werden. Alternativ ist es jedoch auch vorstellbar, abhängig von den beteiligten Materialien lediglich eine einzelne Verbindungsschicht auf einer Schutzschicht 220 vorzusehen.

Im Verlauf des eutektischen Bondens bildet die Verbindungsschicht 110 mit den Verbindungsschichten 211, 212 der Zapfenstruktur 240 ein Eutektikum 300, welches wie in Figur 12 dargestellt in Aussparungen 145 der Nut 140 einfließt. Die Schutzschicht 220 dient hierbei dazu, ein Aufschmelzen von Material der Zapfenstruktur 240 unter der Schutzschicht zu vermeiden, so dass sich das Eutektikum 300 im Wesentlichen mit einem vorgegebenen Mischungsverhältnis erzeugen lässt.

Darüber hinaus kann die Schutzschicht 220 zusammen mit der ebenfalls in dem Herstellungsverfahren der Figuren 11 und 12 vorgesehenen Erhöhung 160 einen mechanischen Anschlag bilden (siehe Figur 12). Auch auf diese Weise kann eine maximale Verdrängung für das aufgeschmolzende Eutektikum 300 beim Verbinden bzw. Aneinanderdrücken der Substrate 100, 200 vorgegeben werden, um ein umfassendes Verdrängen des Eutektikums 300 aus dem Zwischenbereich zwischen der Unterseite der Zapfenstruktur 240 bzw. deren Schutzschicht 220 und der Isolationsschicht 105 zu verhindern. Alternativ besteht auch die Möglichkeit, die in Figur 11 dargestellte Zapfenstruktur 240 mit den Schichten 211, 212, 220 in eine Nut 140 ohne eine Erhöhung einzubringen, wobei ein mechanischer Anschlag durch Abstandshalter 150 entsprechend der in Figur 4 gezeigten Ausführungsform bewirkt werden kann.

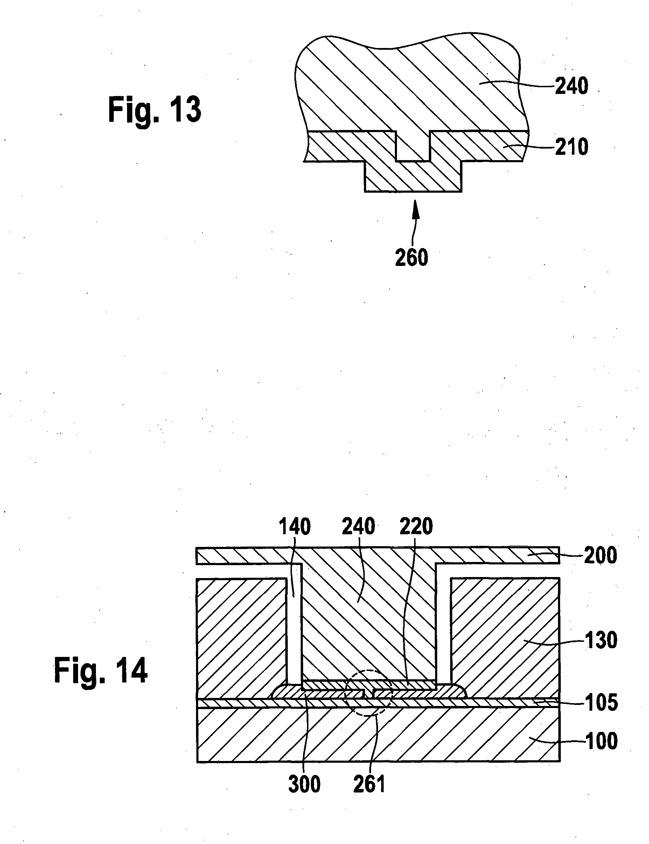

Eine Erhöhung kann neben dem Funktionssubstrat 100 zusätzlich oder alternativ auch auf dem Kappensubstrat 200 bzw. der Zapfen struktur 240 vorgesehen sein. Eine mögliche Ausgestaltung ist in Figur 13 dargestellt. Hierbei ist die Unterseite der Zapfenstruktur 240 bzw. des Bereichs des zugrundeliegenden Substrats 200 strukturiert, um eine Erhöhung 260 bereitzustellen. Eine auf der Zapfenstruktur 240 vorgesehene Verbindungsschicht 210 weist daher im Bereich der Erhöhung 260 einen stufenförmigen Verlauf auf. Auch die Erhöhung 260 der Zapfenstruktur 240 kann wie die oben beschriebenen Erhöhungen 160, 161, 162 auf dem Funktionssubstrat 100 als "Dichtlippe" fungieren, um ein zuverlässiges Verbinden der Substrate 100, 200 trotz Topographieunterschieden zu ermöglichen.

Figur 14 zeigt eine weitere Ausgestaltung mit einer an der Zapfenstruktur 240 vorgesehenen Erhöhung 261. Die Erhöhung 261 wird hierbei durch Strukturieren einer Schutzschicht 220 der Zapfenstruktur 240 bereitgestellt. Vor dem Herstellen der in Figur 14 dargestellten Verbindung der Substrate 100, 200 über das Eutektikum 300 können entsprechend der Ausgestaltung von Figur 11 zwei Verbindungsschichten 211,212 auf der Schutzschicht 220 angeordnet sein, welche im Bereich der Erhöhung 261 eine stufenförmige Form aufweisen (nicht dargestellt). Durch die Erhöhung 261 kann die Schutzschicht 220 zusammen mit der Isolationsschicht 105 einen definierten Anschlag bilden, um ein maximales Verdrängungsmaß für das aufgeschmolzene Eutektikum 300 vorzugeben.

Auch hinsichtlich der in den Figuren 13 und 14 dargestellten Erhöhungen 260, 261 im Bereich der Zapfenstruktur 240 sind weitere alternative Ausgestaltungen vorstellbar. Insbesondere ist es möglich, eine Erhöhung durch eine zusätzliche strukturierte Erhöhungsschicht zu erzeugen oder auch mehrere Erhöhungen an einer Unterseite einer Zapfenstruktur 240 vorzusehen. Für weitere Details wird auf die obigen Ausführungen zu den Erhöhungen 160, 161, 162 auf dem Funktionssubstrat 100 verwiesen. Des weiteren besteht auch hier die Möglichkeit einer Kombination mit Abstandshaltern 150 zwischen den Substraten 100, 200 außerhalb der Nut 140 (nicht dargestellt).

Bei den vorstehend beschriebenen Verfahren erfolgt die Bildung des Eutektikums 300 durch Verschmelzen von auf dem Funktionssubstrat 100 und auf dem Kappensubstrat 200 ausgebildeten Verbindungsschichten 110, 210, 211, 212. Alternativ besteht die Möglichkeit, eine auf dem Funktionssubstrat 100 angeordnete Verbindungsschicht 110 wegzulassen und eine Verbindung direkt mit Substratmaterial an dessen Oberfläche herzustellen.

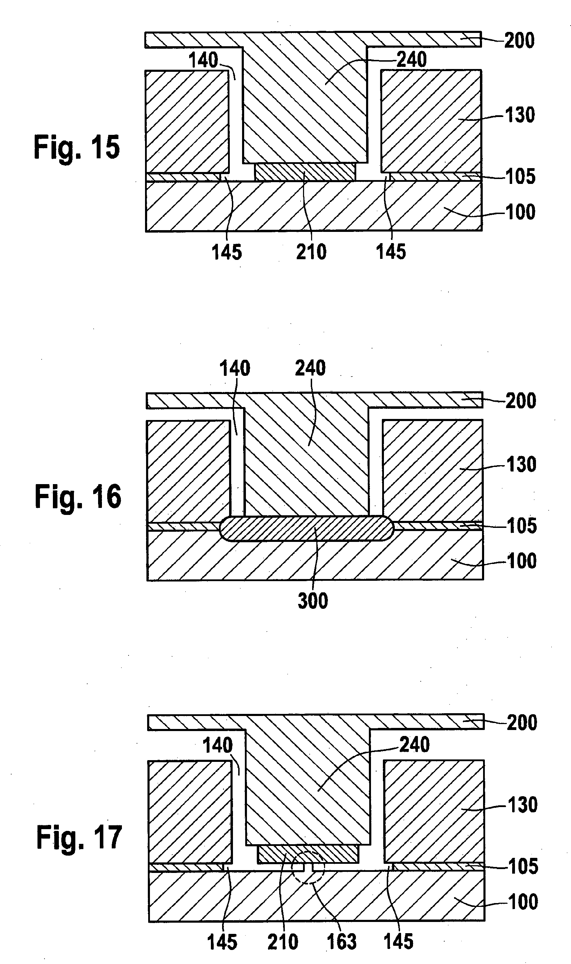

Zur Veranschaulichung zeigen die Figuren 15 und 16 eine mögliche Ausgestaltung eines solchen Verfahrens. Hierbei wird das Funktionssubstrat 100 wie in Figur 15 dargestellt mit einer strukturierten Isolationsschicht 105 und einer strukturierten Funktionsschicht 130 erzeugt, welche eine Nut 140 bereitstellen, wobei die (Silizium-)Oberfläche des (ursprünglichen) Substrats 100 im Bodenbereich der Nut 140 freiliegt. Die Nut 140 weist erneut seitliche Unterätzungen bzw. Aussparungen 145 auf. Eine derartige Struktur kann beispielsweise dadurch ausgebildet werden, dass zunächst eine Schichtanordnung auf dem bereitgestellten Substrat 100 mit einer Isolationsschicht 105 und einer Funktionsschicht 130 erzeugt, und nachfolgend ein Grabenätzen zum Strukturieren der Funktionsschicht 130 und ein Gasphasenätzen zum Entfernen eines Teils der Isolationsschicht 105 durchgeführt wird.

Zum Verbinden der beiden Substrate 100, 200 wird die Zapfenstruktur 240, welche eine Verbindungsschicht 210 auf der Unterseite aufweist, in die Nut 140 eingeführt und ein eutektisches Bondverfahren durchgeführt, bei dem die Substrate 100, 200 unter Einwirkung einer vorgegebenen Temperatur aneinander gedrückt werden. Dies hat zur Folge, dass die Verbindungsschicht 210 und ein Teil des Materials des Substrats 100 an der freiliegenden Oberfläche in der Nut 140 aufschmelzen und zusammen wie in Figur 16 dargestellt ein Eutektikum 300 bilden. Durch das Andrücken der Substrate 100, 200 wird des Weiteren erzielt, dass das Eutektikum 300 in die Aussparungen 145 einfließt und die Aussparungen 145 ausfüllt. Für eine solche eutektische Reaktion kann die Verbindungsschicht 210 beispielsweise Gold aufweisen, welches mit dem Silizium des Substrats 100 verschmelzen kann. Bei der Bildung des Eutektikums 300 kann auch ein Teil der Funktionsschicht 130 im Bereich der Aussparungen 145 sowie ein vor dem Aufschmelzen unter der Verbindungsschicht 210 vorliegenden Teilbereich der Zapfenstruktur 240 beteiligt sein.

Figur 17 veranschaulicht eine Variante des direkten Verbindens mit Substratmaterial an der Oberfläche des Substrats 100. Hierbei ist die freiliegende Oberfläche des Substrats 100 strukturiert ist, so dass eine Erhöhung 163 bereitgestellt wird. Die Erhöhung 163 kann hierbei erneut als "Dichtlippe" fungieren, um ein zuverlässiges Verbinden der Substrate 100, 200 trotz Topographieunterschieden zu ermöglichen. Nach dem Verbinden der Substrate 100, 200 kann die Erhöhung 163 in dem gebildeten Eutektikum 300 "aufgegangen" sein, so dass eine Struktur entsprechend Figur 16 vorliegen kann. Anstelle einer einzelnen Erhöhung 163 können auch mehrere Erhöhungen auf der freiliegenden Oberfläche des Substrats 100 vorgesehen werden.

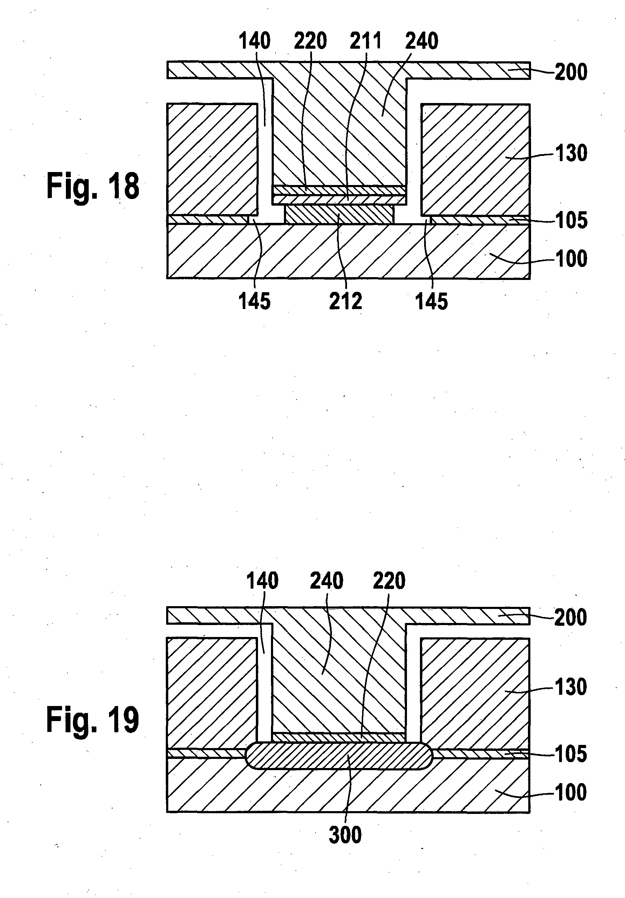

Die Figuren 18 und 19 zeigen eine weitere mögliche Ausführungsform des direkten Verbindens mit Substratmaterial an der Oberfläche des Substrats 100, wobei die Zapfenstruktur 240 des Kappensubstrats 200 hierbei zusätzlich mit einer Schutzschicht 220 und zwei Verbindungsschichten 211, 212 versehen ist. Hierbei kann durch die Schutzschicht 220 ein unerwünschtes Aufschmelzen von Material der Zapfenstruktur 240 beim Bilden des Eutektikums 300 verhindert, und durch die zwei Schichten 211, 212 eine verbesserte Haftung auf der Schutzschicht 220 erzielt werden.

Auch im Hinblick auf die in den Figuren 15 bis 19 veranschaulichten Verfahren ist es vorstellbar, zusätzlich Abstandshalter zwischen den Substraten 100, 200 außerhalb der Nut 140 vorzusehen, um die Substrate 100, 200 in einem definierten Abstand zueinander zu verbinden (nicht dargestellt). Auf diese Weise kann erneut ein maximales Maß für die Verdrängung eines aus der Schicht 210 bzw. den Schichten 211, 212 und dem Substratmaterial des Substrats 100 gebildeten Eutektikums 300 vorgegeben werden. Darüber hinaus kann auch die Unterseite der Zapfenstruktur 240 bzw. deren Schutzschicht 220 mit einer Erhöhung entsprechend den Figuren 13 und 14 versehen werden (nicht dargestellt).

Bei den vorstehend beschriebenen Verfahren weist das Funktionssubstrat 100 eine Nut 140 auf, in welche eine Zapfenstruktur 240 des Kappensubstrats 200 eingreift. Alternativ besteht die Möglichkeit, eine solche Nut 140 wegzulassen, und die Zapfenstruktur 240 ohne ein Zusammenwirken mit einer Nut 140 mit dem Funktionssubstrat 100 zu verbinden. Neben dem Bereitstellen bzw. Umschließen einer Kavität kann die Zapfenstruktur 240 hierbei gegebenenfalls zum Aufbrechen von (nativen) Oxidschichten eingesetzt werden, welche auf Verbindungsschichten 110, 210 vorliegen können.

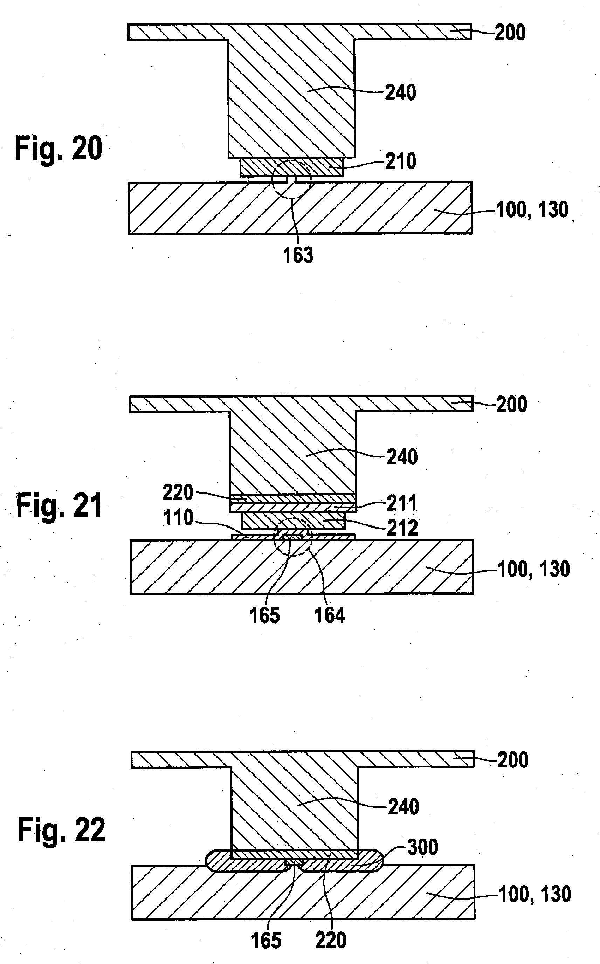

Zur Veranschaulichung zeigt Figur 20 eine mögliche Ausführungsform, bei der auf dem Funktionssubstrat 100 keine Nut 140 ausgebildet ist. Die Zapfenstruktur 240 mit einer an der Unterseite angeordneten Verbindungsschicht 210 wird hierbei direkt mit der Oberfläche des Funktionssubstrats 100 verbunden, so dass sich nach dem Verbinden der Substrate 100, 200 eine mit Figur 16 vergleichbare Ausgestaltung (ohne Nut 140) ergibt. Anstelle die eutektische Verbindung mit einer Oberfläche des Substrats 100 herzustellen, besteht alternativ die Möglichkeit, die Verbindung mit einer auf dem Substrat 100 ausgebildeten Funktionsschicht 130 zu erzeugen. Darüber hinaus ist die Möglichkeit gegeben, auf dem Substrat 100 bzw. auf der Funktionsschicht 130 wie in Figur 20 angedeutet eine Erhöhung 163 auszubilden, welche als "Dichtlippe" zum Ausgleichen von Topographieunterschieden fungiert.

Die Figuren 21 und 22 zeigen eine weitere mögliche Ausgestaltung eines Herstellungsverfahrens. Hierbei ist die Zapfenstruktur 240 wie in Figur 21 dargestellt mit einer Schutzschicht 220 und zwei Verbindungsschichten 211, 212 ausgebildet. Die Schutzschicht 220 verhindert hierbei ein unerwünschtes Aufschmelzen von Material der Zapfenstruktur 240 bei der Ausbildung eines Eutektikums 300. Der zweischichtige Aufbau mit den Verbindungsschichten 211,212 dient dazu, um eine verbesserte Haftung auf der Schutzschicht 220 zu erzielen. Des Weiteren ist auf dem Funktionssubstrat 100 oder auf einer auf dem Substrat 100 angeordneten Funktionsschicht 130 eine weitere Verbindungsschicht 110 angeordnet. Auch weist das Funktionssubstrat 100 eine Erhöhung 164 auf, welche beispielsweise mit Hilfe einer strukturierten Erhöhungsschicht 165 gebildet wird. Nach Herstellen der Verbindung der Substrate 100, 200 über das Eutektikum 300 kann die Erhöhungsschicht 165 weiterhin, wie in Figur 22 dargestellt, in dem Verbindungsbereich zwischen den Substraten 100, 200 vorhanden sein.

Bei den vorstehend anhand der Figuren 1 bis 22 beschriebenen Verfahren erfolgt das Verbinden zwischen einem Funktionssubstrat 100 und einem Kappensubstrat 200 auf der Grundlage eines eutektischen Bondens. Das Verbinden der beiden Substrate 100, 200 kann jedoch auch auf andere Art und Weise erfolgen.

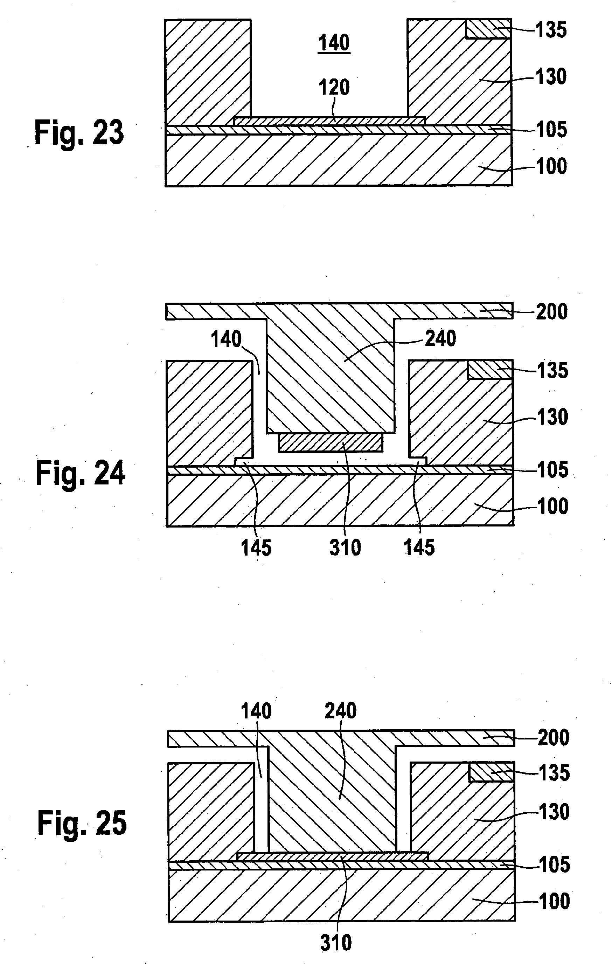

Die Figuren 23 bis 25 zeigen ein weiteres Verfahren zur Herstellung eines mikromechanischen Bauelements aus einem Funktionssubstrat 100 und einem Kappensubstrat 200. Bei dem mikromechanischen Bauelement kann es sich erneut beispielsweise um einen Beschleunigungssensor handeln, welcher in einem Kraftfahrzeug einsetzbar ist.

Figur 23 zeigt eine Darstellung des Funktionssubstrats 100 nach Durchführen einer Reihe von Verfahrensschritten. Zu Beginn wird ein Substrat 100 bereitgestellt, bei dem es sich beispielsweise um einen herkömmlichen Silizium-Wafer handelt. Auf das Substrat 100 wird eine Isolationsschicht 105 aufgebracht, welche beispielsweise Siliziumoxid aufweist. Anstelle einer einzelnen Schicht kann die Isolationsschicht 105 auch mehrere Schichten umfassen. Des weiteren können innerhalb der Isolationsschicht 105 eine oder mehrere eingefasste Leiterbahnebenen vorgesehen sein, um eine Kontaktierung des mikromechanischen Bauelements zu ermöglichen.

Auf der Isolationsschicht 105 wird eine strukturierte Opferschicht 120 ausgebildet, welche beispielsweise Siliziumoxid aufweist. Auf diese Schichtanordnung wird eine relativ dicke Funktionsschicht 130 aufgebracht, in welcher die Funktionselemente des mikromechanischen Bauelements ausgebildet werden. Eine mögliche Lage bzw. ein Bereich der Funktionselemente ist in Figur 23 anhand eines Sensorbereichs 135 angedeutet. Bei der Funktionsschicht 130 kann es sich um eine Epi-Polysiliziumschicht handeln.

Das Erzeugen von Funktionselementen in dem Sensorbereich 135 umfasst das Durchführen eines Grabenätzverfahrens, zum Beispiel Trenchen, in dessen Verlauf wie in Figur 23 dargestellt eine Ausnehmung bzw. Nut 140 in der Funktionsschicht 130 ausgebildet wird, welche eine (in der Aufsicht) geschlossene und den Sensorbereich 135 umlaufende Form aufweist. Die Opferschicht 120 kann hierbei als Ätzstoppschicht fungieren.

Ein weiterer im Rahmen des Herstellens der Mikrostruktur in dem Sensorbereich 135 durchgeführter Prozess ist ein Gasphasenätzprozess (beispielsweise mit Flusssäuredampf), um die durch das Grabenätzen vorstrukturierten Funktionselemente der Mikrostruktur freizulegen. Im Hinblick auf die Nut 140 hat das Gasphasenätzen zur Folge, dass die Opferschicht 120 wie in Figur 24 dargestellt entfernt wird, so dass Seitenwände der Nut 140 angrenzend an den durch die Isolationsschicht 105 gebildeten Bodenbereich Unterätzungen bzw. Aussparungen 145 aufweisen.

Figur 24 zeigt des Weiteren das Kappensubstrat 200, welches mit dem Funktionssubstrat 100 zum Herstellen des mikromechanischen Bauelements verbunden wird. Das Kappensubstrat 200 dient dazu, um den Sensorbereich 135 hermetisch gegenüber der Umgebung abzudichten.

Figur 24 zeigt eine Darstellung des Kappensubstrats 200 nach Durchführen einer Reihe von Verfahrensschritten. Zu Beginn wird ein Substrat 200 bereitgestellt, bei dem es sich wie bei dem (ursprünglichen) Substrat 100 beispielsweise um einen Silizium-Wafer handeln kann. Das Substrat 200 wird ferner mit einer hervorstehenden Zapfenstruktur 240 versehen, welche mittels eines Strukturierungs- bzw. Ätzverfahren hergestellt wird. Die Zapfenstruktur 240 ist auf die Nut 140 des Funktionssubstrats 100 abgestimmt und weist daher wie die Nut 140 eine (in der Aufsicht) geschlossene umlaufende Form auf. Durch das Strukturieren der Zapfenstruktur 240 wird des weiteren eine Kavität bzw. Kaverne auf dem Kappensubstrat 200 ausgebildet, welche von der Zapfenstruktur 240 eingefasst wird.

Nach dem Verbinden der Substrate 100, 200 ist der Sensorbereich 135 des Funktionssubstrats 100 innerhalb der Kavität angeordnet.

Auf einer Unterseite ist die Zapfenstruktur 240 ferner mit einem Verbindungsmedium 310 versehen. Als Material für das Verbindungsmedium 310 kommt beispielsweise ein Lot in Betracht, welches insbesondere eine im eutektischen Verhältnis aufgebrachte Metalllegierung (zum Beispiel Gold-Silizium oder Aluminium-Germanium) umfasst. Zum Aufbringen eines solchen Verbindungsmediums 310 kann beispielsweise ein Sputterprozess durchgeführt werden. In einem solchen Fall kann das Verbindungsmedium 310 vor oder alternativ nach dem Strukturieren der Zapfenstruktur 240 auf das Kappensubstrat 200 aufgebracht werden, so dass eine Strukturierung des Verbindungsmediums 310 im Rahmen der Strukturierung der Zapfenstruktur 240 oder durch ein zusätzliches Strukturierungsverfahren erfolgen kann. Möglich ist es auch, auf eine Strukturierung des (auf die Zapfenstruktur 240 aufgebrachten) Verbindungsmediums 310 zu verzichten, so dass das Verbindungsmedium 310 auch Seitenwände der Zapfenstruktur 240 bedecken kann (nicht dargestellt). Alternativ ist es vorstellbar, für das Verbindungsmedium 310 ein Sealglas oder einen Klebstoff einzusetzen. Derartige Materialien können beispielsweise durch einen Siebdruck- oder Dispenseprozess auf die Zapfenstruktur 240 aufgetragen werden.

Zum Verbinden der beiden Substrate 100, 200 wird die Zapfenstruktur 240 wie in Figur 24 gezeigt in die Nut 140 eingeführt, und werden die beiden Substrate 100, 200 aneinander gedrückt, so dass das Verbindungsmedium 310 wie in Figur 25 dargestellt verdrängt und in die Aussparungen 145 gepresst wird. Dieser Vorgang kann abhängig von dem Material des Verbindungsmediums 310 bei einer vorgegebenen Temperatur durchgeführt werden, so dass beispielsweise bei Einsatz eines metallischen Lotes als Verbindungsmedium 310 ein Aufschmelzen bewirkt wird. Nach einem Erstarren oder Aushärten des Verbindungsmediums 310 sind die beiden Substrate 100, 200 hermetisch dicht miteinander verbunden. Das beschriebene Verbinden der beiden Substrate 100, 200 kann bei einer definierten Atmosphäre mit einem vorgegebenen (beispielsweise sehr geringen) Atmosphärendruck durchgeführt werden, um einen definierten Innendruck in der von den beiden Substraten 100, 200 eingefassten Kavität einzustellen, in welchem der Sensorbereich 135 angeordnet ist.

Das Eingreifen der Zapfenstruktur 240 in die Nut 140 ermöglicht eine hohe Verbindungsfestigkeit des mikromechanischen Bauelements, vor allem gegenüber lateral zwischen den Substraten 100, 200 wirkenden Kräften bzw. Scherkräften. Das Ausfüllen der seitlichen Aussparungen 145 der Nut 140 durch das Verbindungsmedium bewirkt darüber hinaus eine Verkeilung bzw. Verzahnung, wodurch die Verbindungsfestigkeit weiter begünstigt wird.

Bei Einsatz eines metallischen Lotes als Verbindungsmedium 310 ist des Weiteren von Vorteil, dass ein Aufschmelzen des Verbindungsmediums 310 bzw. Bilden einer Schmelze bewirkt wird, auch wenn sich die Substrate 100, 200 (lokal) nicht direkt berühren. Auf diese Weise kann das aufgeschmolzene Verbindungsmedium 310 selbst bei Topographieunterschieden oder auch bei Vorliegen von Partikeln zwischen den Substraten 100, 200, welche eine direkte Berührung gegebenenfalls verhindern, in die Nut 140 und die Aussparungen 145 verfließen, so dass eine dichte Verbindung zwischen den Substraten 100, 200 herstellbar ist.

Anhand der folgenden Figuren werden Abwandlungen bzw. Variationen des anhand der Figuren 23 bis 25 erläuterten Herstellungsverfahrens beschrieben. Auf Details zu übereinstimmenden bzw. entsprechenden Verfahrensschritten und Komponenten wird daher auf die obigen Ausführungen Bezug genommen. Auch wird darauf hingewiesen, dass Merkmale von einzelnen Ausführungsformen auch mit anderen Varianten kombiniert werden können. Dies trifft in entsprechender Weise auf Merkmale der anhand der Figuren 1 bis 22 erläuterten Verfahren zu.

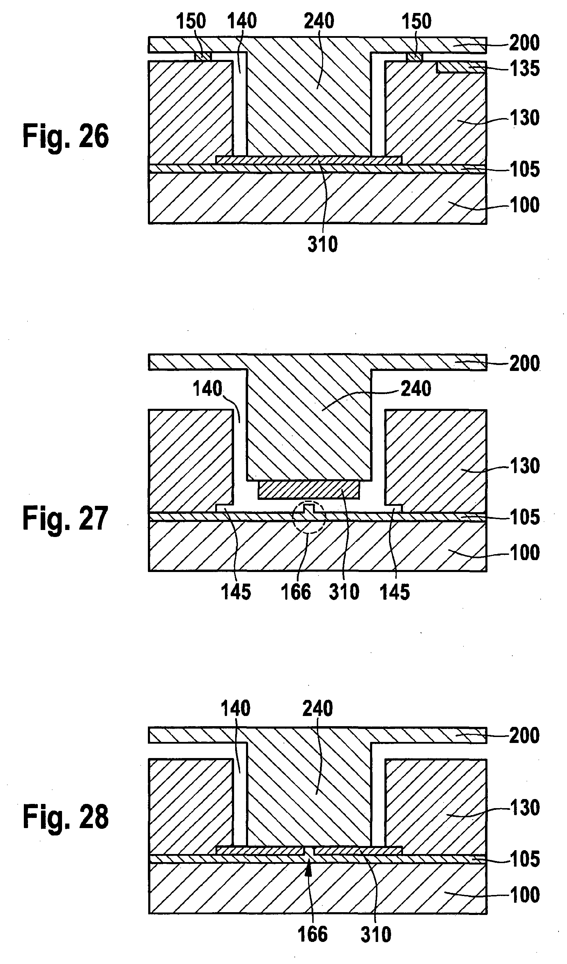

Figur 26 zeigt eine alternative Ausgestaltung, wobei zwischen dem Funktionssubstrat 100 bzw. der Funktionsschicht 130 und dem Kappensubstrat 200 außerhalb der Nut 140 Abstandshalter 150 vorgesehen sind. Die Abstandshalter 150 werden vor dem Verbinden der Substrate 100, 200 hergestellt. Das Erzeugen der Abstandshalter 150 umfasst beispielsweise ein Strukturieren der Funktionsschicht 130 oder ein Aufbringen einer weiteren Schicht (zum Beispiel aus Siliziumoxid) auf der Funktionsschicht 130 und Strukturieren der weiteren Schicht.

Durch die Abstandshalter 150 können die beiden Substrate 100, 200 in einem definierten Abstand zueinander angeordnet werden. Der definierte Abstand bietet beispielsweise die Möglichkeit, die Position bzw. Bewegung eines Funktionselements der Mikrostruktur des Funktionssubstrats 100 mit einer hohen Genauigkeit kapazitiv über eine in dem Kappensubstrat 200 angeordnete Bezugselektrode zu erfassen. Des Weiteren können die Abstandshalter 150 dazu verwendet werden, um ein maximales Maß an Verdrängung für das Verbindungsmedium 310 beim Verbinden bzw. Aneinanderdrücken der Substrate 100, 200 festzulegen. Auf diese Weise kann insbesondere sichergestellt werden, dass das Verbindungsmedium 310 nicht vollständig aus dem Zwischenbereich zwischen der Unterseite der Zapfenstruktur 240 und der Isolationsschicht 105 herausgedrängt wird, was gegebenenfalls eine Verschlechterung der Haftung und/oder Abdichtung zur Folge hat.

Anstelle die Abstandshalter 150 auf dem Funktionssubstrat 100 bzw. der Funktionsschicht 130 vorzusehen, ist es auch möglich, die Abstandshalter 150 neben der Zapfenstruktur 240 auf dem Kappensubstrat 200 auszubilden. Dies kann beispielsweise durch Strukturieren des Kappensubstrats 200 oder Aufbringen einer weiteren Schicht auf das Kappensubstrat 200 und Strukturieren derselben erfolgen. Des weiteren ist es auch vorstellbar, die beiden Substrate 100, 200 derart zu verbinden, dass die in den Figuren seitlich von der Zapfenstruktur 240 angedeutete Kante bzw. Oberfläche des Kappensubstrats 200 oder ein Teilbereich hiervon auf der Funktionsschicht 130 aufliegt (nicht dargestellt). Auch auf diese Weise kann ein definierter Abstand zwischen den Substraten 100, 200 mit den oben beschriebenen Wirkungen festgelegt werden.

Die Figuren 27 und 28 zeigen eine weitere Ausgestaltung, des Herstellungsverfahrens vor und nach dem Verbinden der Substrate 100, 200. Hierbei ist zusätzlich eine Erhöhung 166 auf dem Funktionssubstrat 100 vorgesehen. Die Erhöhung 166 dient dazu, einen definierten Abstand bzw. einen mechanischen Anschlag zwischen den Substraten 100, 200 vorzugeben. Auf diese Weise kann entsprechend den Abstandshaltern 150 ein (maximales) Maß für die Verdrängung des Verbindungsmediums 310 beim Verbinden der Substrate 100, 200 festgelegt werden. Die Erhöhung 166 wird beispielsweise durch zusätzliches Strukturieren der auf das (ursprüngliche) Substrat 100 aufgebrachten Isolationsschicht 105 (bzw. einer oder mehrerer Schichten der als Schichtensystem aufgebauten Isolationsschicht 105) erzeugt. Darüber hinaus kann die Erhöhung 166 gegebenenfalls auch als "Dichtlippe" fungieren, um trotz Topographieunterschieden zwischen den Substraten 100, 200 eine hermetisch dichte Verbindung in dem gesamten Verbindungsbereich zu erzielen.

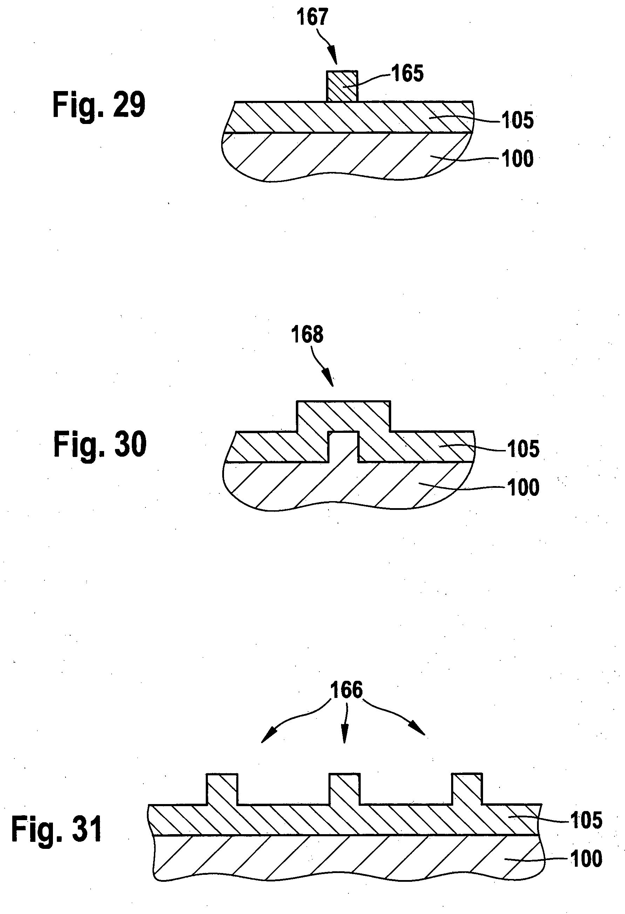

Eine solche Erhöhungsstruktur (innerhalb der Nut 140) kann auch auf andere Art und Weise verwirklicht werden. Eine mögliche Ausgestaltung ist die in Figur 29 dargestellte Erhöhung 167, welche durch eine auf der Isolationsschicht 105 ausgebildete strukturierte Erhöhungsschicht 165 bereitgestellt wird. Die Erhöhungsschicht 165 weist vorzugsweise ein temperaturbeständiges Material auf, um insbesondere im Zusammenhang mit nachfolgenden und bei hohen Temperaturen durchgeführten Prozessen (zum Beispiel Aufbringen der Schicht 130 in einem Epitaxie-Reaktor) verwendet zu werden. Mögliche temperaturbeständige Materiallen für die Erhöhungsschicht 165 sind zum Beispiel Polysilizium, Siliziumnitrit, Siliziumkarbid oder Siliziumoxid.

Des Weiteren ist es denkbar, das bereitgestellte Substrat 100 zu strukturieren, um, wie in Figur 30 dargestellt, eine Erhöhung 168 bereitzustellen. Hierbei weist die nachfolgend ausgebildete Isolationsschicht 105 im Bereich der Erhöhung 162 einen entsprechenden stufenförmigen Verlauf auf. Figur 31 zeigt eine weitere mögliche Ausgestaltung, wobei mehrere, d.h. beispielsweise drei in einem gleichen Abstand bzw. parallel zueinander angeordnete Erhöhungen 166 auf dem Funktionssubstrat 100 vorgesehen sind.

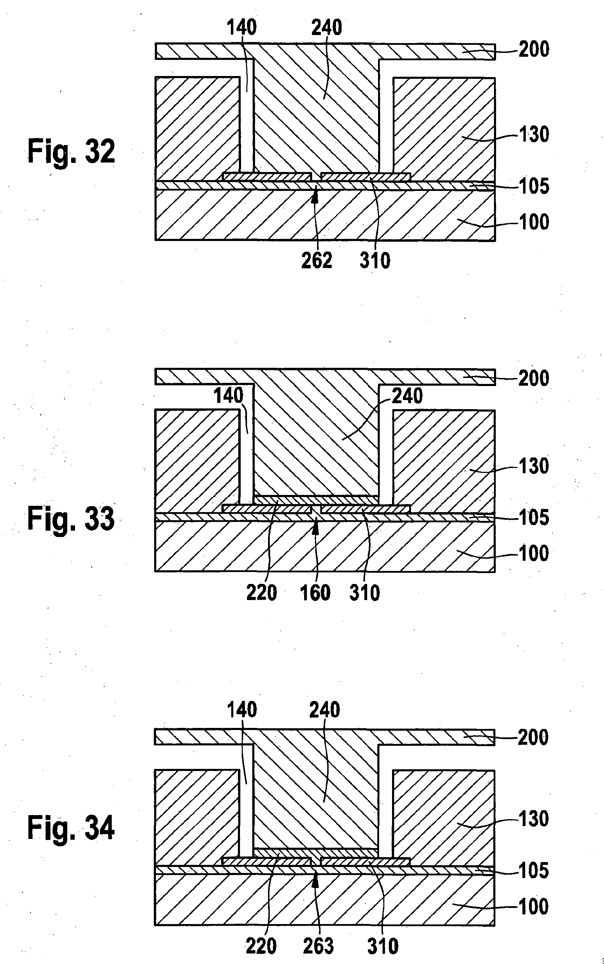

Eine Erhöhung kann neben dem Funktionssubstrat 100 zusätzlich oder alternativ auch auf dem Kappensubstrat 200 bzw. auf der Zapfenstruktur 240 vorgesehen sein. Eine mögliche Ausgestaltung ist in Figur 32 dargestellt. Hierbei ist die Unterseite der Zapfenstruktur 240 strukturiert, um eine Erhöhung 262 bereitzustellen. Auch die Erhöhung 262 der Zapfenstruktur 240 kann zum Bereitstellen eines mechanischen Anschlags sowie gegebenenfalls als "Dichtlippe" fungieren. Hinsichtlich des Einsatzes von Erhöhungsstrukturen auf dem Funktionssubstrat 100 in der Nut 140 und/oder auf der Zapfenstruktur 240 des Kappensubstrat 200 besteht die Möglichkeit, diese auch mit den in Figur 26 dargestellten Abstandshaltern 150 zu kombinieren (nicht dargestellt).

Figur 33 zeigt eine weitere Ausführungsform des Herstellungsverfahrens. Hierbei ist die Zapfenstruktur 240 mit einer zusätzlichen Schutzschicht 220 versehen, welche beispielsweise Siliziumoxid aufweist. Vor Herstellen der in Figur 33 dargestellten Anordnung ist das Verbindungsmedium 310 auf dieser Schutzschicht 220 angeordnet. Die Schutzschicht 220 kann hierbei ein unerwünschtes Aufschmelzen von Material der Zapfenstruktur 240 verhindern, was beispielsweise bei Einsatz eines Gold-Silizium-Eutektikums als Verbindungsmedium 310 der Fall sein kann.

Eine weitere Variante ist in Figur 34 dargestellt. Hierbei ist die Schutzschicht 220 der Zapfenstruktur 240 zusätzlich strukturiert, um eine Erhöhung 263 bereitzustellen. Auf diese Weise besitzt die Schutzschicht 220 zusätzlich die oben beschriebene Funktion als mechanischer Anschlag sowie gegebenenfalls als "Dichtlippe".

Die anhand der Figuren erläuterten Ausführungsformen stellen bevorzugte bzw. beispielhafte Ausführungsformen der Erfindung dar. Anstelle der beschriebenen Ausführungsformen sind weitere Ausführungsformen vorstellbar, welche weitere Abwandlungen oder Kombinationen umfassen können. Darüber hinaus ist es möglich, eine hervorstehende Zapfenstruktur auf einem Funktionssubstrat (zum Beispiel durch Strukturieren einer Funktionsschicht) auszubilden, und ein solches Funktionssubstrat über die Zapfenstruktur mit einem Kappensubstrat zu verbinden. Hierbei kann das Kappensubstrat gegebenenfalls eine Ausnehmung bzw. Nut aufweisen, in welche die Zapfenstruktur eingreift. Auch in einer solchen Ausführungsform können die oben beschriebenen Verfahren in entsprechender Weise zum Einsatz kommen.

## Patentansprüche

1. Verfahren zum Herstellen eines mikromechanischen Bauelements, umfassend die Verfahrensschritte:
Bereitstellen eines ersten Substrats (100),
Bereitstellen eines zweiten Substrats (200),
Ausbilden einer Ausnehmung (140) auf dem ersten Substrat (100), wobei die Ausnehmung (140) einen Bodenbereich und Seitenwände umfasst,
Ausbilden eines hervorstehenden Strukturelements (240) auf dem zweiten Substrat (200), und
Verbinden des ersten und zweiten Substrats (100, 200) über das hervorstehende Strukturelement (240), wobei das erste und zweite Substrat (100, 200) derart verbunden werden, dass das hervorstehende Strukturelement (240) des zweiten Substrats (200) in die Ausnehmung (140) des ersten Substrats (100) eingreift,
**dadurch gekennzeichnet,**
**dass** das Verbinden des ersten und zweiten Substrats (100, 200) ein eutektisches Bonden umfasst,
und **dass** die Seitenwände der Ausnehmung (140) des ersten Substrats (100) angrenzend an den Bodenbereich Aussparungen (145) aufweisen, in welche eine bei dem eutektischen Bonden gebildete eutektische Legierung (300) einfließt.

2. Verfahren nach Anspruch 1, wobei das hervorstehende Strukturelement (240) des zweiten Substrats (200) mit einer Verbindungsschicht (210, 211, 212) ausgebildet wird, und wobei bei dem Verbinden des ersten und zweiten Substrats (100, 200) die Verbindungsschicht (210, 211, 212) und Material des ersten Substrats (100) die eutektische Legierung (300) bilden.

3. Verfahren nach einem der vorhergehenden Ansprüche, wobei eine erste Verbindungsschicht (110) auf dem ersten Substrat (100) ausgebildet wird, wobei das hervorstehende Strukturelement (240) des zweiten Substrats (200) mit einer zweiten Verbindungsschicht (210, 211, 212) ausgebildet wird, und wobei bei dem Verbinden des ersten und zweiten Substrats (100, 200) die erste und zweite Verbindungsschicht (110, 210, 211, 212) die eutektische Legierung (300) bilden.

4. Verfahren nach Anspruch 3, wobei eine Isolationsschicht (105) auf dem ersten Substrat ausgebildet wird, auf welcher die erste Verbindungsschicht ausgebildet (110) wird.

5. Verfahren nach einem der vorhergehenden Ansprüche, wobei das hervorstehende Strukturelement (240) des zweiten Substrats (200) mit einer Schutzschicht (220) ausgebildet wird, auf welcher die Verbindungsschicht (211) des hervorstehenden Strukturelements (240) ausgebildet wird, und wobei die Schutzschicht (220) ein Aufschmelzen von Material des hervorstehenden Strukturelements (240) unter der Schutzschicht (220) bei dem Verbinden des ersten und zweiten Substrats (100, 200) verhindert.

6. Verfahren nach Anspruch 5, wobei die Verbindungsschicht des hervorstehenden Strukturelements zwei aufeinander angeordnete Schichten (211, 212) mit unterschiedlichen Materialien aufweist.

7. Verfahren nach einem der vorhergehenden Ansprüche, wobei vor dem Verbinden der beiden Substrate (100, 200) Abstandshalter (150) außerhalb der Ausnehmung (140) auf dem ersten Substrat (100) oder neben dem hervorstehenden Strukturelement (240) auf dem zweiten Substrat (200) ausgebildet werden, um die beiden Substrate (100, 200) in einem definierten Abstand zueinander anzuordnen.

8. Verfahren nach einem der vorhergehenden Ansprüche, wobei eine Erhöhungsstruktur (160, 161, 162, 163, 164, 165, 260, 261) in einem Verbindungsbereich auf dem ersten Substrat (100) oder auf dem hervorstehenden Strukturelement (240) des zweiten Substrats (200) ausgebildet wird.

9. Verfahren nach Anspruch 8, wobei die Erhöhungsstruktur einen mechanischen Anschlag bildet, um bei dem Verbinden der beiden Substrate (100, 200) ein vollständiges Herausdrängen der eutektischen Legierung (300) zwischen dem Bodenbereich der Ausnehmung (140) des ersten Substrats (100) und dem hervorstehenden Strukturelement (240) des zweiten Substrats (200) zu verhindern.

10. Mikromechanisches Bauelement, aufweisend:
ein erstes Substrat (100), welches eine Ausnehmung (140) aufweist,
ein zweites Substrat (200), welches ein hervorstehendes Strukturelement (240) aufweist,
wobei das erste und zweite Substrat (100, 200) derart verbunden sind, dass das hervorstehende Strukturelement (240) in die Ausnehmung (140) eingreift,
und wobei die Verbindung des ersten und zweiten Substrats (100, 200) durch ein in der Ausnehmung angeordnetes Verbindungsmedium (300, 310) hergestellt ist,
**dadurch gekennzeichnet, dass**
die Ausnehmung (140) des ersten Substrats (100) einen Bodenbereich und Seitenwände umfasst, wobei die Seitenwände angrenzend an den Bodenbereich Aussparungen (145) aufweisen, welche von dem Verbindungsmedium (300, 310) ausgefüllt sind,
und dass das Verbindungsmedium (300, 310) eine eutektische Legierung ist.

11. Mikromechanisches Bauelement nach Anspruch 10, wobei das erste Substrat (100) eine Isolationsschicht (105) aufweist, welche mit dem Verbindungsmedium (300, 310) verbunden ist.

12. Mikromechanisches Bauelement nach einem der Ansprüche 10 oder 11, wobei das hervorstehende Strukturelement (240) des zweiten Substrats (200) eine Schutzschicht (220) aufweist, welche mit dem Verbindungsmedium (300, 310) verbunden ist.

13. Mikromechanisches Bauelement nach einem der Ansprüche 10 bis 12, weiter aufweisend Abstandshalter (150) zwischen dem ersten und zweiten Substrat (100, 200) außerhalb der Ausnehmung (140).

14. Mikromechanisches Bauelement nach einem der Ansprüche 10 bis 13, weiter aufweisend eine Erhöhungsstruktur (160, 161, 162, 163, 166, 167, 168, 260, 261, 262, 263) auf dem ersten Substrat (100) in der Ausnehmung (140) oder auf dem hervorstehenden Strukturelement (240) des zweiten Substrats (200).

## Claims

1. Method for producing a micromechanical component, comprising the method steps of:
providing a first substrate (100),
providing a second substrate (200),
forming a recess (140) on the first substrate (100), the recess (140) comprising a base region and side walls,
forming a protruding structural element (240) on the second substrate (200), and
connecting the first and the second substrate (100, 200) via the protruding structural element (240), the first and the second substrate (100, 200) being connected in such a manner that the protruding structural element (240) of the second substrate (200) engages into the recess (140) of the first substrate (100),
**characterized**
**in that** the connection of the first and of the second substrate (100, 200) comprises eutectic bonding,
and **in that**, adjacent to the base region, the side walls of the recess (140) of the first substrate (100) have cutouts (145), into which a eutectic alloy (300) formed during the eutectic bonding flows.

2. Method according to Claim 1, wherein the protruding structural element (240) of the second substrate (200) is formed with a connecting layer (210, 211, 212), and wherein, during the connection of the first and of the second substrate (100, 200), the connecting layer (210, 211, 212) and material of the first substrate (100) form the eutectic alloy (300).

3. Method according to either of the preceding claims, wherein a first connecting layer (110) is formed on the first substrate (100), wherein the protruding structural element (240) of the second substrate (200) is formed with a second connecting layer (210, 211, 212), and wherein, during the connection of the first and of the second substrate (100, 200), the first and the second connecting layer (110, 210, 211, 212) form the eutectic alloy (300).

4. Method according to Claim 3, wherein an insulation layer (105) is formed on the first substrate, and the first connecting layer (110) is formed on said insulation layer.

5. Method according to one of the preceding claims, wherein the protruding structural element (240) of the second substrate (200) is formed with a protective layer (220), on which the connecting layer (211) of the protruding structural element (240) is formed, and wherein the protective layer (220) prevents melting of material of the protruding structural element (240) beneath the protective layer (220) during the connection of the first and of the second substrate (100, 200).

6. Method according to Claim 5, wherein the connecting layer of the protruding structural element has two layers (211, 212) which are arranged one on top of the other and which comprise different materials.

7. Method according to one of the preceding claims, wherein, before the connection of the two substrates (100, 200), spacers (150) are formed outside the recess (140) on the first substrate (100) or alongside the protruding structural element (240) on the second substrate (200) in order to arrange the two substrates (100, 200) at a defined spacing apart.

8. Method according to one of the preceding claims, wherein an elevation structure (160, 161, 162, 163, 164, 165, 260, 261) is formed in a connecting region on the first substrate (100) or on the protruding structural element (240) of the second substrate (200).

9. Method according to Claim 8, wherein the elevation structure forms a mechanical stop, in order to prevent, during the connection of the two substrates (100, 200), complete ejection of the eutectic alloy (300) between the base region of the recess (140) of the first substrate (100) and the protruding structural element (240) of the second substrate (200).

10. Micromechanical component, having:
a first substrate (100), which has a recess (140),
a second substrate (200), which has a protruding structural element (240),
the first and the second substrate (100, 200) being connected in such a manner that the protruding structural element (240) engages into the recess (140),
and the connection of the first and of the second substrate (100, 200) being produced by a connecting medium (300, 310) arranged in the recess,
**characterized in that**
the recess (140) of the first substrate (100) comprises a base region and side walls, wherein, adjacent to the base region, the side walls have cutouts (145) filled by the connecting medium (300, 310),
and **in that** the connecting medium (300, 310) is a eutectic alloy.

11. Micromechanical component according to Claim 10, wherein the first substrate (100) has an insulation layer (105), which is connected to the connecting medium (300, 310).

12. Micromechanical component according to either of Claims 10 and 11, wherein the protruding structural element (240) of the second substrate (200) has a protective layer (220), which is connected to the connecting medium (300, 310).

13. Micromechanical component according to one of Claims 10 to 12, further having spacers (150) between the first and the second substrate (100, 200) outside the recess (140).

14. Micromechanical component according to one of Claims 10 to 13, further having an elevation structure (160, 161, 162, 163, 166, 167, 168, 260, 261, 262, 263) on the first substrate (100) in the recess (140) or on the protruding structural element (240) of the second substrate (200).

## Revendications

1. Procédé de fabrication d'un composant micromécanique, comprenant les étapes de procédé suivantes :
fourniture d'un premier substrat (100),
fourniture d'un deuxième substrat (200),
réalisation d'un évidement (140) sur le premier substrat (100), l'évidement (140) comprenant une région de fond et des parois latérales,
réalisation d'un élément structurel saillant (240) sur le deuxième substrat (200), et
assemblage du premier et du deuxième substrat (100, 200) par le biais de l'élément structurel saillant (240), le premier et le deuxième substrat (100, 200) étant assemblés de telle sorte que l'élément structurel saillant (240) du deuxième substrat (200) s'engage dans l'évidement (140) du premier substrat (100),
**caractérisé en ce que**
l'assemblage du premier et du deuxième substrat (100, 200) comprend une liaison eutectique,
et **en ce que** les parois latérales de l'évidement (140) du premier substrat (100) présentent, en position adjacente à la région de fond, des parties en creux (145) dans lesquelles s'écoule un alliage eutectique (300) formé par la liaison eutectique.

2. Procédé selon la revendication 1, dans lequel l'élément structurel saillant (240) du deuxième substrat (200) est réalisé avec une couche d'assemblage (210, 211, 212), et, lors de l'assemblage du premier et du deuxième substrat (100, 200), la couche d'assemblage (210, 211, 212) et le matériau du premier substrat (100) forment l'alliage eutectique (300).

3. Procédé selon l'une quelconque des revendications précédentes, dans lequel une première couche d'assemblage (110) est réalisée sur le premier substrat (100), l'élément structurel saillant (240) du deuxième substrat (200) étant réalisé avec une deuxième couche d'assemblage (210, 211, 212), et, lors de l'assemblage du premier et du deuxième substrat (100, 200), la première et la deuxième couche d'assemblage (110, 210, 211, 212) formant l'alliage eutectique (300).

4. Procédé selon la revendication 3, dans lequel une couche d'isolation (105) est réalisée sur le premier substrat, sur laquelle est réalisée la première couche d'assemblage (110).

5. Procédé selon l'une quelconque des revendications précédentes, dans lequel l'élément structurel saillant (240) du deuxième substrat (200) est réalisé avec une couche de protection (220), sur laquelle est réalisée la couche d'assemblage (211) de l'élément structurel saillant (240), et dans lequel la couche de protection (220) empêche une fusion de matériau de l'élément structurel saillant (240) sous la couche de protection (220) lors de l'assemblage du premier et du deuxième substrat (100, 200).

6. Procédé selon la revendication 5, dans lequel la couche d'assemblage de l'élément structurel saillant présente deux couches (211, 212) disposées l'une sur l'autre avec des matériaux différents.

7. Procédé selon l'une quelconque des revendications précédentes, dans lequel avant l'assemblage des deux substrats (100, 200), des éléments d'espacement (150) sont réalisés à l'extérieur de l'évidement (140) sur le premier substrat (100) ou à proximité de l'élément structurel saillant (240) sur le deuxième substrat (200), afin de disposer les deux substrats (100, 200) à une distance définie l'un par rapport à l'autre.

8. Procédé selon l'une quelconque des revendications précédentes, dans lequel une structure de rehaussement (160, 161, 162, 163, 164, 165, 260, 261) est réalisée dans une région d'assemblage sur le premier substrat (100) ou sur l'élément structurel saillant (240) du deuxième substrat (200).

9. Procédé selon la revendication 8, dans lequel la structure de rehaussement forme une butée mécanique afin d'empêcher, lors de l'assemblage des deux substrats (100, 200), que l'alliage eutectique (300) ne ressorte complètement entre la région de fond de l'évidement (140) du premier substrat (100) et l'élément structurel saillant (240) du deuxième substrat (200).

10. Composant micromécanique, présentant :
un premier substrat (100), qui présente un évidement (140),
un deuxième substrat (200), qui présente un élément structurel saillant (240),
le premier et le deuxième substrat (100, 200) étant assemblés de telle sorte que l'élément structurel saillant (240) s'engage dans l'évidement (140),
et dans lequel l'assemblage du premier et du deuxième substrat (100, 200) est réalisé par un milieu d'assemblage (300, 310) disposé dans l'évidement,
**caractérisé en ce que** l'évidement (140) du premier substrat (100) comprend une région de fond et des parois latérales, les parois latérales présentant, en position adjacente à la région de fond, des parties en creux (145) qui sont remplies avec le milieu d'assemblage (300, 310),
et **en ce que** le milieu d'assemblage (300, 310) est un alliage eutectique.

11. Composant micromécanique selon la revendication 10, dans lequel le premier substrat (100) présente une couche d'isolation (105) qui est assemblée au milieu d'assemblage (300, 310).

12. Composant micromécanique selon l'une quelconque des revendications 10 ou 11, dans lequel l'élément structurel saillant (240) du deuxième substrat (200) présente une couche de protection (220) qui est assemblée au milieu d'assemblage (300, 310).

13. Composant micromécanique selon l'une quelconque des revendications 10 à 12, présentant en outre des éléments d'espacement (150) entre le premier et le deuxième substrat (100, 200) à l'extérieur de l'évidement (140).

14. Composant micromécanique selon l'une quelconque des revendications 10 à 13, présentant en outre une structure de rehaussement (160, 161, 162, 163, 166, 167, 168, 260, 261, 262, 263) sur le premier substrat (100) et dans l'évidement (140) ou sur l'élément structurel saillant (240) du deuxième substrat (200).
